(19) Europäisches Patentamt / European Patent Office / Office européen des brevets

(11) **EP 3 759 424 B1**

(12) **EUROPÄISCHE PATENTSCHRIFT**

(45) Veröffentlichungstag und Bekanntmachung des Hinweises auf die Patenterteilung:
**29.05.2024   Patentblatt 2024/22**

(21) Anmeldenummer: **18712511.7**

(22) Anmeldetag: **27.02.2018**

(51) Internationale Patentklassifikation (IPC):
**G01B 11/00** *(2006.01)*     **G01B 11/27** *(2006.01)*
**G03F 9/00** *(2006.01)*

(52) Gemeinsame Patentklassifikation (CPC):
**G01B 11/002; G01B 11/272; G03F 9/7011;
G03F 9/7015; G03F 9/7046; G03F 9/7076;
G03F 9/7088;** G01B 2210/56

(86) Internationale Anmeldenummer:
**PCT/EP2018/054840**

(87) Internationale Veröffentlichungsnummer:
**WO 2019/166078 (06.09.2019 Gazette 2019/36)**

(54) **MARKENFELD, VERFAHREN UND VORRICHTUNG ZUR BESTIMMUNG VON POSITIONEN**

MARK FIELD, METHOD AND DEVICE FOR DETERMINING POSITIONS

ZONE DE REPÈRES, PROCÉDÉ ET DISPOSITIF DE DÉTERMINATION DE POSITIONS

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**

(43) Veröffentlichungstag der Anmeldung:
**06.01.2021   Patentblatt 2021/01**

(73) Patentinhaber: **EV Group E. Thallner GmbH
4782 St. Florian am Inn (AT)**

(72) Erfinder:
• **WAGENLEITNER, Thomas
4971 Aurolzmünster (AT)**

• **BÖGELSACK, Frank
4970 Eitzing (AT)**

(74) Vertreter: **Schneider, Sascha et al
Becker & Müller
Patentanwälte
Turmstraße 22
40878 Ratingen (DE)**

(56) Entgegenhaltungen:
**EP-A1- 1 832 933          EP-A2- 1 921 506
WO-A1-2014/202106     JP-A- 2011 170 144
US-A1- 2011 228 242**

**Beschreibung**

Die vorliegende Erfindung betrifft eine Vorrichtung zur Bestimmung von X-Y-Positionen von Strukturmerkmalen von auf einem Substrat angeordneten Strukturen nach Anspruch 1 sowie ein korrespondierendes Verfahren nach Anspruch 8.

In der Industrie ist es von entscheidender Bedeutung, eine Aussage über die Position von Strukturen auf einem Substrat zu erhalten. Von besonderem Interesse ist die Differenz zwischen der realen Ist-Position und der idealen Soll-Position einer Struktur. Um die Ist-Positionen von Strukturen zu bestimmen kann man ein Koordinatensystem einführen und die Position der Strukturen in Bezug zu diesem Koordinatensystem angeben. Meistens handelt es sich dabei um ein körperfestes, d.h. dem Substrat zugeordnetes, Koordinatensystem. Das Koordinatensystem wird im weiteren Verlauf als Substratkoordinatensystem bezeichnet. EP1932933A1 offenbart ein Verfahren zur Herstellung eines Geräts unter Verwendung eines Substrats, wobei eine Nanoeinprägetechnik verwendet wird.

Um allerdings alle Strukturen vermessen zu können, muss eine Relativbewegung zwischen dem Substrat und dem Vermessungssystem, insbesondere einem optischen System mit Kamera, erfolgen. Das ist notwendig, da sich nicht alle Strukturen im Sichtbereich des Vermessungssystems befinden. Würden sich alle zu vermessenden Strukturen im Sichtbereich des Vermessungssystems befinden, wäre eine Relativbewegung zwischen dem Vermessungssystem, und dem Substrat natürlich nicht notwendig.

Die Relativbewegung erfolgt meistens durch eine aktive Bewegung des Substrathalters, auf dem das Substrat fixiert ist, damit das filigrane optische System nicht bewegt werden muss. In diesem Fall muss die Position des Substrathalters sehr genau bestimmt werden, um die Distanzen bestimmen zu können, die der Substrathalter zurückgelegt hat. Die Position des Substrathalters muss also in Bezug zu einem raumfesten Koordinatensystem angegeben werden.

Denkbar wäre auch, nur den zurückgelegten Weg des Substrathalters zwischen zwei Punkten zu bestimmen. In diesem Fall wird zwar auf ein raumfestes Koordinatensystem verzichtet, es wird aber dennoch eine sehr präzise Steuerungsanlage benötigt, um die zurückgelegten Distanzen sehr genau bestimmen zu können.

Jede genannte Methode aus dem Stand der Technik benötigt relativ teure und komplizierte elektronisch-mechanische Systeme, um die Position beziehungsweise den zurückgelegten Weg des Substrathalters und damit die Strukturpositionen an der Substratoberfläche eines Substrats vermessen zu können. Des Weiteren sind die Verfahrwege derartiger Anlagen erheblich. Durch die entsprechende Baugröße haben bereits kleinste Temperaturschwankungen einen Einfluss auf die thermischen Dehnungen und damit die Bauteilgrößen der verwendeten Bauteile.

Um Strukturen, die sich nicht gleichzeitig im Sichtbereich einer Optik befinden, an der Substratoberfläche eines Substrats vermessen zu können, muss eine Relativbewegung zwischen dem Substrat und der Optik erfolgen, um die Strukturen nacheinander in den Sichtbereich der Optik zu bringen. Meistens verfährt der Substrathalter, auf dem das Substrat fixiert wird, während die Optiken fixiert sind. Während der Fahrt muss die Position des Substrathalters kontinuierlich mitverfolgt werden. Man benötigt also ein Bezugssystem in Bezug zu dem die Position des Substrathalters angegeben wird. Die Positionsangabe des Substrathalters und damit des Substrats muss sehr genau erfolgen, insbesondere im Nanometerbereich. Diese exakte Positionsangabe, insbesondere über Wegstrecken von mehreren Zentimetern, erfordert sehr genaue und somit teure Messsysteme, insbesondere Interferometer.

Aufgabe der vorliegenden Erfindung ist es daher, eine Vorrichtung und ein Verfahren zum Vermessen von Substraten anzugeben, mit dem eine genauere und/oder effizientere Bestimmung der Positionen von Strukturen oder Strukturmerkmalen auf Substraten ermöglicht wird.

Diese Aufgabe wird mit den Merkmalen der Ansprüche 1 und 8 gelöst. Vorteilhafte Weiterbildungen der Erfindung sind in den Unteransprüchen angegeben. Der Schutzbereich wird durch die Ansprüche definiert.

Der Erfindung liegt der Gedanke zugrunde, ein Markenfeld mit

-   mindestens zwei Lagemarken mit Informationen zur Lage der jeweiligen Lagemarke im Markenfeld und
-   mindestens eine einer der Lagemarken zugeordnete oder zuordenbare Positionsmarke zur Bestimmung von X-Y-Positionen von Strukturmerkmalen von Strukturen auf einem Substrat, insbesondere unabhängig von einer Bewegung oder Position eines Substrathalters vorzusehen.

Die erfindungsgemäße Vermessung der Strukturen eines Substrats erlaubt in weiteren Prozessschritten insbesondere einen genaueren und effizienteren Bondvorgang zweier Substrate zueinander. Entsprechen die vermessenen Strukturpositionen nicht den gewünschten Strukturpositionen erfolgt insbesondere vor und/oder während dem Bondvorgang eine Kompensation mindestens eines der beiden Substrate.

Mit anderen Worten werden vorzugsweise Substratpaare nach Auswahlkriterien gebildet.

Insbesondere wird erfindungsgemäß aus zwei X-Y-Positionen oder aus weiteren Merkmalen der Lagemarken und/oder Positionsmarke(n) eine Lage, insbesondere Rotationslage, der Strukturen bestimmt.

Weiterhin ist es erfindungsgemäß denkbar, aus zwei X-Y-Positionen oder aus weiteren Merkmalen der Lagemarken und/oder Positionsmarke(n) Dehnungen oder Zerrungen der Strukturen zu bestimmen.

Ein, insbesondere eigenständiger, Erfindungsaspekt liegt darin, einzelne X-Y-Positionen von Strukturmerkmalen von Strukturen an der Substratoberfläche eines Substrats mit Positionsmarken auf einer, der Substratoberfläche des Substrats gegenüberlegenden, Oberfläche zu assoziieren beziehungsweise in Relation zu setzen, insbesondere deren Abstände in X- und/oder Y-Richtung zu bestimmen. Dazu werden neben den Positionsmarken insbesondere zusätzlich Lagemarken verwendet. Durch die Verwendung derartiger Positions- und Lagemarken ist es nicht mehr notwendig, die Position des Substrathalters hochpräzise mit technisch aufwendigen, insbesondere optischen, Messsystemen zu bestimmen oder mit zu verfolgen. Eine grobe Bestimmung der aktuellen Position erfolgt insbesondere durch das Auslesen und Interpretieren der Lagemarken. Eine präzisere Bestimmung der aktuellen Position kann insbesondere durch zusätzliche, vorzugsweise den Lagemarken zugeordnete, Positionsmarken erfolgen.

Die Erfindung beschreibt somit insbesondere eine Methode und eine Vorrichtung zur Bestimmung, insbesondere Vermessung, vorzugsweise Positionsvermessung, von Strukturen oder Strukturmerkmalen, ohne die Position des Substrathalters, und damit die Position des Substrats, relativ zu einem (anderen) Bezugssystem ermitteln zu müssen.

Ein weiterer, insbesondere eigenständiger Kern der Erfindung besteht darin, eine Methode und eine Vorrichtung vorzusehen, mit deren Hilfe insbesondere gänzlich auf die Verwendung eines raumfesten Bezugssystems, in Bezug zu dem die X-Y-Position des Substrathalters angegeben beziehungsweise vermessen wird, verzichtet werden kann.

Der Grundgedanke besteht insbesondere darin, ein Markenfeld, vorzugsweise an einer Oberfläche, auszubilden, welches der Substratoberfläche, auf der die Strukturen oder Strukturmerkmale vermessen werden sollen, gegenüberliegend angeordnet ist oder anordenbar ist.

Das Markenfeld verfügt insbesondere über zwei Eigenschaften: Jede Marke des Markenfelds ist so kodiert, dass ein Messsystem, insbesondere eine Optik, auf die Lage der Marke rückschließen kann. Bei Kenntnis dieser Lage kann die Vorrichtung mittels hochgenauer, vorzugsweise der jeweiligen Lagemarke zugeordnete, Positionsmarken eine hochgenaue Positionsbestimmung durchführen.

Bei Kenntnis des Markenfeldes und der Verwendung zweier zueinander kalibrierter Optiken, können so die Strukturen/Strukturmerkmale von der Substratoberfläche des zu vermessenden Substrats mit den Marken assoziiert werden und vice versa. Dadurch werden Berechnungen, insbesondere von Abstandsänderungen möglich, ohne dass ein raumfestes äußeres Bezugssystem notwendig wäre.

Es werden keine raumfesten Bezugssysteme mehr benötigt, in Bezug zu denen die Position des Substrathalters aufgezeichnet werden müssen. Man muss also nicht mehr die Position des Substrathalters nachverfolgen, weder optisch mit Hilfe von Interferometern noch mechanisch mit Hilfe von Schrittzählern. Es ist daher in Weiterbildung der Erfindung vorgesehen, dass, insbesondere über die nachfolgend beschriebenen erfindungsgemäß offenbarten Mittel hinaus keine Mittel zur, insbesondere laufenden, Erfassung der Position des Substrathalters verwendet werden oder vorrichtungsgemäß installiert sind.

Ein wesentlicher weiterer Aspekt der vorliegenden Erfindung besteht insbesondere darin, Verzerrungen des Markenfeldes und/oder der Positionsmarken zu reduzieren beziehungsweise weitestgehend zu vermeiden.

## Marke

Unter einer Marke wird erfindungsgemäß im weitesten Sinne eine optisch erfassbare und/oder topographisch erfassbare Struktur (oder Strukturmerkmale der Struktur) verstanden, die beziehungsweise deren Position, vorzugsweise zumindest deren X-Y-Position, mit Hilfe eines Messinstruments detektiert und somit bestimmt werden kann. Messinstrumente zur Erfassung der Strukturen/Strukturmerkmale und somit Bestimmung deren Position können insbesondere sein:

- Optische Systeme, insbesondere Kameras
- Kontaktierende Systeme, insbesondere AFM.

Eine Marke besteht vorzugsweise aus mindestens einem der nachfolgend aufgeführten Materialien:

    ◦ Metall, insbesondere

        ◦ Cr, Al, Ti, Cu, Ag, Au, Fe, Ni, Co, Pt, W, Pb, Ta, Zn, Sn,

    o Legierung, insbesondere

        o Metalllegierung,
        ◦ Metall-Nichtmetalllegieruig,

    ◦ Keramik,
    o Kunststoff,
    o Halbleiter, insbesondere

        o Verbindungshalbleiter, insbesondere

            ▪ GaAs, GaN, InP, InxGal-xN ,InSb, InAs, GaSb, AIN, InN, GaP, BeTe, ZnO, CuInGaSe2, ZnS, ZnSe, ZnTe, CdS, CdSe, CdTe, Hg(1-x)Cd(x)Te, BeSe, HgS, AlxGal-xAs, GaS, GaSe, GaTe, InS, InSe, InTe, CuInSe2, CuInS2, CuInGaS2, SiC, SiGe,

        o Halbleiter, insbesondere

▪ Ge, Si, Alpha-Sn, Fullerene, B, Se, Te.

Vorzugsweise werden die Marken optisch detektiert, daher werden nachfolgend optische Vermessungen beschrieben. Eine Marke besteht insbesondere aus einer Lagemarke und einer Positionsmarke. Lagemarken sind erfindungsgemäß vorzugsweise kodierbare oder kodierte Marken, also Informationsträger. Positionsmarken werden, insbesondere ausschließlich, für die Bestimmung einer hochgenauen Position, insbesondere X-Y-Position, verwendet.

Insbesondere sind die Lagemarke und eine der Lagemarke zugeordnete Positionsmarke gleichzeitig im Sichtbereich der jeweils verwendeten Optik erfassbar. Vorzugsweise ist die Lagemarke, insbesondere jede Lagemarke, in der näheren Umgebung der zugeordneten Positionsmarke angeordnet, damit die gleichzeitige Erfassung sichergestellt wird.

Denkbar ist es gemäß einer vorteilhaften Ausführungsform der Erfindung, dass die Lagemarke eine oder mehrere Positionsmarken aufweist.

Die Lagemarken sind insbesondere kleiner als 5mm x 5mm, vorzugsweise kleiner als 1mm x 1mm, noch bevorzugter kleiner als 0.1mm x 0.1mm, am bevorzugtesten kleiner als $0.01mm \times 0.01mm$, am allerbevorzugtesten kleiner als 0.001mm x 0.001mm. Besonders bevorzugt weisen die Lagemarken eine Breite oder einen Durchmesser zwischen $20\mu m$ und $200\mu m$ auf.

Die Positionsmarken sind insbesondere kleiner als $0.1mm \times 0.1mm$, vorzugsweise kleiner als $0.01mm \times 0.01mm$, noch bevorzugter kleiner als 0.001mm x 0.001mm, am bevorzugtesten kleiner als 0.0001mm x 0.0001mm, am allerbevorzugtesten kleiner als 0.00001mm x 0.00001 mm.

Die Lage- und/oder die Positionsmarken sind vorzugsweise Teile eines im Computer erzeugten Musters. Die Positionen der Lage und Positionsmarken im digitalen Muster sind als ideal anzusehen. Durch die Herstellung der Lage- und Positionsmarken, insbesondere mittels Schicht-, Masken- Ätz-und Entwicklungstechniken entstehen die realen Lage- und Positionsmarken. Die Positionen dieser realen Lage- und Positionsmarken werden, insbesondere auf Grund der fehlerbehafteten Prozesse und Anlagen, von der gewünschten Idealposition abweichen. Diese Abweichungen sind vorzugsweise minimal und liegen im Nanometerbereich. Die Genauigkeit der Lage- und Positionsmarken ist daher umso größer, je weniger die Idealpositionen von den Realpositionen abweichen. Die Abweichungen sind insbesondere kleiner als $1\mu m$, vorzugsweise kleiner als 500nm, noch bevorzugter kleiner als 250nm, am bevorzugtesten kleiner als 50nm, am allerbevorzugtesten kleiner als 10nm.

Ein weiterer Aspekt der Erfindung besteht darin, Fertigungsungenauigkeiten des Markenfeldträgers, insbesondere der Marken, vor allem der eigentlich hochgenau herzustellenden Positionsmarken, in Kauf zu nehmen. Die Vorrichtung weist demnach insbesondere ein Markenfeld auf, dessen Positionsmarken nicht hochpräzise gefertigt wurden, wodurch Produktionskosten erheblich gesenkt werden können.

Um dennoch auf ein Positionsmarkenfeld zurückgreifen zu können, das über hochpräzise Positionen verfügt, wird ein Sollpositionsmarkenfeld, insbesondere in einem Computer gespeichert, hinterlegt. Die Positionen der Positionsmarken im Computer sind als ideal anzusehen, während die tatsächlichen Positionen des hergestellten Positionsmarkenfeldes (Ist-Positionen) hiervon abweichen können. In einem Justierprozess wird das Markenfeld des Markenfeldträgers vermessen (Ermittlung der Ist-Positionen) und die Relativpositionen zwischen den idealen Positionsmarken im Computer und den realen Positionsmarken auf dem Markenfeldträger ermittelt und gespeichert.

Hieraus wird zu jeder realen Positionsmarke eine entsprechende Korrektur in Bezug zur idealen Positionsmarke berechnet, insbesondere in Form eines auf die jeweilige Position bezogenen Vektors. Mit dieser Methode ist es möglich, die Strukturen auf dem Substrat mit den realen Positionsmarken auf dem Markenfeldträger und diese wiederum mit den idealen Positionsmarken im Computer zu korrelieren. Durch diese Idee lassen sich die Fertigungskosten des Markenfeldträgers, insbesondere durch eine ungenauere Herstellung des Markenfeldes, immens senken und führen so zu einem wirtschaftlichen Vorteil.

Erfindungsgemäß ist jede Lagemarke in einem Markenfeld individualisiert. Durch die Individualisierung ist eine Verwechslung unterschiedlicher Lagemarken ausgeschlossen, so dass durch die Erfassung jeder Lagemarke auf einen X-Y-Koordinatenbereich der Lagemarke auf dem Markenfeld geschlossen werden kann. Das Koordinatensystem des Markenfeldes wird insbesondere als Markenfeldkoordinatensystem bezeichnet.

Bei der Lagemarke handelt es sich vorzugsweise um eine oder mehrere der folgenden Ausprägungen:

- QR Code,
- Strichcode,
- Geometrische, insbesondere dreidimensionale, Figur,
- Zeichenfolge, insbesondre Buchstabenfolge und/oder Zahlenfolge, vorzugsweise Binärcode,
- Bild.

Die Lagemarke ist insbesondere ein Informationsträger. Vorzugsweise wird jede Lagemarke mit einer X-Y-Position codiert, die angibt, an welcher Position im Raster sich die Lagemarke befindet, also in welchem X-Y-Koordinatenbereich die Lagemarke verortet ist.

Die Positionsmarken können als einfache oder komplexe Gebilde konstruiert sein. Auf die genaue Form der Positionsmarken wird nicht näher eingegangen, da diese im Stand der Technik als solche bekannt sind. In den Figuren werden die Positionsmarken insbesondere als Kreuz dargestellt. Positionsmarken werden vorzugsweise gleich gefertigt und sehen vorzugsweise gleich aus, wie die im Stand der Technik sehr gebräuchlichen Ausrichtungsmarken. Damit können die Techniken, die aus dem Stand der Technik für die Analyse von Ausrichtungsmarken Verwendung finden auch für die Analyse der Positionsmarken verwendet werden.

In ganz besonderes bevorzugten erfindungsgemäßen Ausführungsformen umgibt, insbesondere umschließt, die Positionsmarke die Lagemarke. In diesem Fall ist die Positionsmarke insbesondere als Kreis, Rechteck, Oktagon oder eine beliebige andere geometrische Figur, die leicht von einer Software erkannt und ausgewertet werden kann, ausgeführt.

**Markenfeld**

Das Markenfeld besteht insbesondere aus einer Menge von, vorzugsweise hochsymmetrisch zueinander angeordneten Marken, d.h. Lage- und Positionsmarken, erfindungsgemäß bedeutend ist vor allem, dass die Positionsmarken zueinander hochpräzise hergestellt werden. Die einer Positionsmarke zugeordnete oder zuordenbare Lagemarke wird so angeordnet, dass sich beide vorzugsweise gleichzeitig im Sichtbereich der Optik befinden. Die Lagemarke dient, insbesondere ausschließlich, dem Auslesen der ungefähren Lageposition, im weiteren Verlauf des Textes nur mehr als Lage bezeichnet, welche von der Optik beobachtet wird. Vorzugsweise ist die Relativposition zwischen jeder Lagemarke und der zugeordneten Positionsmarke identisch. Das erleichtert die Programmierung eines Auswertealgorithmus und somit das Aufsuchen der Lage- und/oder Positionsmarken im Markenfeld, sobald sich beide im Sichtbereich der Optik befinden.

In einer ganz besonders bevorzugten Ausführungsform wird die Lagemarke von der Positionsmarke, insbesondere vollumfänglich, umgeben, insbesondere umschlossen.

Somit kann die Fertigungsgenauigkeit der Lagemarken geringer sein als die der Positionsmarken, wodurch die Herstellungskosten für das Markenfeld minimiert werden.

Sollte das Markenfeld aus Marken bestehen, bei denen die Lagemarke und die Positionsmarke miteinander verschmelzt wurden, werden vorzugsweise alle Marken des Markenfeldes hochpräzise hergestellt, da jede Marke gleichzeitig Lagemarke und Positionsmarke ist, also beide Funktionen aufweist.

Vorzugsweise sind die Marken in einem, insbesondere symmetrischen, Raster mit einheitlichen Abständen zwischen den Lagemarken angeordnet. Die benachbarten Lagemarken und/oder Positionsmarken sind vorzugsweise äquidistant auf dem Markenfeld angeordnet. In einem Markenfeld befinden sich insbesondere mehr als 10 x 10 Marken, vorzugsweise mehr als 100 x 100 Marken, noch bevorzugter mehr als 1000 x 1000 Marken, am bevorzugtesten mehr als 10000 x 10000 Marken, am allerbevorzugtesten mehr als 100000 x 100000 Marken. Abstände zwischen benachbarten Lagemarken sind insbesondere kleiner als die Breite und/oder Höhe oder der Durchmesser der Lagemarken. Vorzugsweise ist das Verhältnis zwischen dem Abstand und der Breite und/oder Höhe oder dem Durchmesser der Lagemarken kleiner als 1, noch bevorzugter kleiner als 0.5, noch bevorzugter kleiner als 0.1.

Vorzugsweise kodieren die Lagemarken die X-Y-Position im Raster. Dadurch ist es möglich, bei Erfassung der Lagemarke auf den jeweiligen Rasterbereich zu schließen, der von den Erfassungsmitteln, insbesondere einer oder mehreren Optiken, gerade erfasst wird. Denkbar ist die Kodierung zusätzlicher Informationen in jeder Lagemarke, beispielsweise die Lage der zugeordneten Positionsmarke zur Lagemarke.

Der Vollständigkeit halber wird offenbart, dass sich die Marken nicht auf einem hochsymmetrischen Raster befinden müssen. Die Verteilung der Marken kann beliebig sein, solange die Abstandbeziehungen (Vektoren oder X-Y-Abstände) zwischen den Positionsmarken bekannt und die jeweiligen Lagemarken mit ihren entsprechenden Positionsmarken assoziierbar sind. Eine Verteilung der Marken auf einem nicht symmetrischen Raster stellt eine verschlechterte Ausführungsform dar.

Das Markenfeld wird vorzugsweise einerseits so nahe wie möglich an der Substratoberfläche angeordnet, an der sich die Strukturen befinden, die vermessen werden sollen beziehungsweise deren X-Y-Positionen erfindungsgemäß bestimmt werden. Andererseits sollen die Strukturen, die das Markenfeld bilden, vor Beschädigungen geschützt werden.

Der Abstand zwischen den zu vermessenden Strukturen und dem Markenfeldträger liegt vorzugsweise zwischen 0.1mm und 100mm, vorzugsweise zwischen 0.25mm und 75mm, noch bevorzugter zwischen 0.5mm und 50mm, am bevorzugtesten zwischen 1mm und 30mm, am allerbevorzugtesten zwischen 5mm und 20mm.

Insbesondere wird das Markenfeld an der dem Substrat abgewandten Seite des Markenfeldträgers angeordnet, um es vor mechanischer Belastung und Abrieb zu schützen, da es auf diese Weise nicht direkt mit dem Substrat in Kontakt kommt. Denkbar ist auch, dass das Markenfeld mit einer transparenten Beschichtung überzogen wird, um es vor mechanischen und/oder chemischen Einflüssen zu schützen.

**Markenfeldträger**

Ein erfindungsgemäßer Markenfeldträger ist das oder sind die Bauteile, auf denen ein Markenfeld aufgebracht ist/wird.

Gemäß einer ersten erfindungsgemäßen Ausführungsform ist der Substrathalter selbst der Markenfeldträger. Das Markenfeld befindet sich auf einer der beiden Oberflächen des Substrathalters, vorzugsweise auf der Fixieroberfläche, auf der das Substrat fixiert wird.

Befindet sich das Markenfeld auf der Fixieroberfläche, wird der Substrathalter zumindest unterhalb des Markenfeldes vorzugsweise zumindest teilweise transparent ausgebildet in Bezug auf die elektromagnetische Strahlung, mit der das Markenfeld beobachtet wird.

Befindet sich das Markenfeld auf der, der Fixieroberfläche gegenüberliegenden, Oberfläche, kann der Substrathalter auch intransparent sein.

In einer zweiten, besonders bevorzugten erfindungsgemäßen Ausführungsform handelt es sich bei dem Markenfeldträger um ein eigenständiges Bauteil, welches in oder an dem Substrathalter fixierbar ist und damit schnell ausgetauscht werden kann.

Vorzugsweise ist auch in diesem Fall das Markenfeld an der Fixieroberfläche angebracht und das Bauteil zumindest teilweise transparent für die verwendete elektromagnetische Strahlung. Durch diese Ausführung kann der Markenfeldträger vom Substrathalter getrennt hergestellt werden. Hierdurch wird die Flexibilität erhöht und ein Austausch erleichtert. Weiterhin können die Produktionskosten gesenkt werden.

Gemäß einer erfindungsgemäßen Erweiterung wird der Substrathalter so konstruiert, dass der Markenfeldträger in diesen einsetzbar ist und ausschließlich peripher unterstützt wird. In dieser besonderen Ausführungsform wird der Markenfeldträger möglichst dick konstruiert, sodass der Biegewiderstand möglichst groß ist und eine Verzerrung der Positionsmarken minimiert wird, vorzugsweise gänzlich entfällt. Der nur peripher gestützte Markenfeldträger wird durch die Gravitationskraft umso stärker durchgebogen, je dünner er ausgebildet ist. Die Durchbiegung führt zu einer Streckung der Markenfeldträgeroberfläche, die in Richtung der Gravitation zeigt. Folglich würde auch das Markenfeld gestaucht werden, wodurch die Qualität der Bestimmung der X-Y-Positionen sinkt.

Gemäß einer anderen erfindungsgemäßen Erweiterung wird der Substrathalter so konstruiert, dass der Markenfeldträger in den Substrathalter eingesetzt werden kann und nicht nur peripher, sondern durch, insbesondere im Zentrum zusammenlaufende, Streben auch von unten unterstützt wird. Die Streben minimieren vor allem eine Durchbiegung des Markenfeldträgers. Vorzugsweise sind die Streben zumindest teilweise transparent für die bei der Erfassung der X-Y-Position der Strukturen verwendete elektromagnetische Strahlung. Sind die Streben intransparent, kann entlang der durch die Streben verdeckten Fläche keine Korrelation zwischen den Marken des Markenfeldes und den Strukturen auf der Substratoberfläche hergestellt werden.

Der Transmissionsgrad des Markenfeldhalters und/oder der Streben ist insbesondere größer als 10%, vorzugsweise größer als 25%, noch bevorzugter größer als 50%, am bevorzugtesten größer als 75%, am allerbevorzugtesten größer als 95%.

Dem Problem der Durchbiegung kann vor allem mit einem möglichst dicken Markenfeldträger entgegengewirkt werden. Die Dicke des Markenfeldträgers ist insbesondere größer als 1mm, vorzugsweise größer als 2mm, noch bevorzugter größer als 5mm, am bevorzugtesten größer als 20mm, am allerbevorzugtesten größer als 30mm. Je dicker der Markenfeldträger ist, desto größer ist sein Biegewiderstand und desto weniger stark kann der Markenfeldträger durch Biegung verformt werden.

Die Substrate können jede beliebige Form besitzen, sind aber bevorzugt kreisrund. Der Durchmesser der Substrate ist insbesondere industriell genormt. Für Wafer sind die industrieüblichen Durchmesser, 1 Zoll, 2 Zoll, 3 Zoll, 4 Zoll, 5 Zoll, 6 Zoll, 8 Zoll, 12 Zoll und 18 Zoll. Die erfindungsgemäße Ausführungsform kann aber grundsätzlich jedes Substrat, unabhängig von dessen Durchmesser handhaben.

Der Markenfeldträger und/oder das Markenfeld weisen einen Durchmesser und/oder eine Umfangskontur auf, der insbesondere dem Durchmesser des Substrats weitgehend entspricht.

In besonderen Ausführungsformen ist der Durchmesser des Markenfeldträgers größer als der des Substrates, insbesondere größer als 1.01 mal, vorzugsweise größer als 1.05 mal, noch bevorzugter größer als 1.1 mal, am bevorzugtesten größer als 1.2 mal, am allerbevorzugtesten größer als 1.2 mal der Durchmesser des Substrats.

Gemäß einer erfindungsgemäßen Weiterbildung sind die Streben möglichst transparent. Vorzugsweise werden die Streben selbst aus einem Material gefertigt, das vollkommen transparent für die verwendete elektromagnetische Strahlung ist. Denkbar ist auch, die Streben so weit wie möglich mit Nuten und Löchern zu versehen, um möglichst viele Sichtbereiche für die verwendete Optik zu schaffen. Die Nuten und Löcher können, insbesondere formschlüssig und/oder bündig, mit transparenten Einsätzen verschlossen werden, um die redezierte Stützwirkung wieder zu erhöhen.

Der Markenfeldträger wird vorzugsweise aus mindestens einem der folgenden Materialien, zumindest teilweise, gefertigt

- Metall, insbesondere

    ◦ Cu, Ag, Au, Al, Fe, Ni, Co, Pt, W, Cr, Pb, Ti, Ta, Zn, Sn und/oder

- Kunststoff, insbesondere

    ◦ Elastomere, insbesondere

        ▪ Viton (Werkstoff) und/oder
        ▪ Polyurethane und/oder
        ▪ Hypalon (Werkstoff) und/oder
        ▪ Isopren-Kautschuk (Werkstoff) und/oder
        ▪ Nitril-Kautschuk (Werkstoff) und/oder
        ▪ Perfluorokautschuk (Werkstoff) und/oder
        ▪ Polyisobuten (Werkstoff),

○ Thermoplastische Elastomere und/oder

- Halbleitermaterial, insbesondere

  ○ Verbindungshalbleiter

    ▪ GaAs, GaN, InP, InxGaI-xN ,InSb, InAs, GaSb, AIN, InN, GaP, BeTe, ZnO, CuInGaSe2, ZnS, ZnSe, ZnTe, CdS, CdSe, CdTe, Hg(1-x)Cd(x)Te, BeSe, HgS, AlxGaI-xAs, GaS, GaSe, GaTe, InS, InSe, InTe, CuInSe2, CuInS2, CuInGaS2, SiC, SiGe

  ○ Halbleiter, insbesondere

    ▪ Ge, Si, Alpha-Sn, Fullerene, B, Se, Te

- Glas, insbesondere

  ○ Metallische Gläser
  ○ Nichtmetallische Gläser, insbesondere

    ▪ Organische nichtmetallische Gläser
    ▪ Anorganische nichtmetallische Gläser, insbesondere

      - Nichtoxidische Gläser, insbesondere

        ○ Halogenidgläser
        ○ Chalkogenidgläser

      - Oxidische Gläser, insbesondere

        ○ Phosphatische Gläser
        ○ Silikatische Gläser, insbesondere

          ▪ Alumosilikatgläser
          ▪ Bleisilikatgläser
          ▪ Alkali-Silikatgläser, insbesondere

            - Alkali-Erdalkalisilikatgläser

          ▪ Borosilikatgläser

        ○ Boratgläser, insbesondere

          ▪ Alkaliboratgläser

        ○ Quarz

- Keramik

- Mineralien, insbesondere Saphir.

Der Markenfeldträger ist vorzugsweise

- Zylinderförmig,
- Quaderförmig (bevorzugt).

Grundsätzlich kann der Markenfeldträger allerdings jede beliebige Form annehmen.

Die Markenfeldträger werden vorzugsweise aus einem Werkstoff gefertigt, der einen sehr geringen thermischen Ausdehnungskoeffizienten besitzt, damit Temperaturschwankungen nicht zu einer Verzerrung des Markenfeldträgers und damit des Markenfeldes führen.

Besteht der Markenfeldträger aus einem Werkstoff, der einen nicht verschwindend geringen thermischen Ausdehnungskoeffizienten besitzt, so wird der Markenfeldträger vorzugsweise so eingebaut, dass die Markenfeldoberfläche dehnungsbehindert ist, sich also trotz etwaiger Temperaturschwankungen oder -abweichungen nicht ausdehnen kann. Diesen Zustand wird konstruktionstechnisch insbesondere dadurch gelöst, dass der Markenfeldträger in ein Bauteil, insbesondere einen Substrathalter, eingebaut wird, welches selbst aus einem Werkstoff mit geringem thermischen Ausdehnungskoeffizienten besteht.

Der thermische Ausdehnungskoeffizient des Markenfeldträgers sollte möglichst klein sein, um eine Verzerrung des Markenfeldträgers beziehungsweise des Bauteils, welches den Markenfeldträger dehnungsbehindert, durch Temperaturdifferenzen zu verhindern. Der thermische Ausdehnungskoeffizient ist insbesondere kleiner als $10^{-4}K^{-1}$, vorzugsweise kleiner als $5*10^{-5}K^{-1}$, noch bevorzugter kleiner als $10^{-5}K^{-1}$, am bevorzugtesten kleiner als $5*10^{-6}K^{-1}$, am bevorzugtesten kleiner als $10^{-6}K^{-1}$, am allerbevorzugtesten kleiner als $10^{-7}K^{-1}$.

Das Markenfeld wird vorzugsweise am Markenfeldträger bei Kontakt des Markenfeldträgers mit dem zu messenden Substrat möglichst nahe an den zu messenden Strukturen des Substrats angeordnet. Durch die gezielte Minimierung des Abstandes zwischen dem Markenfeld und den zu vermessenden Strukturen wird ein etwaiger optischer Fehler, der durch die Ausrichtung von optischen Achsen zueinander kalibrierter Optiken entstehen kann, minimiert.

In den Ausführungsformen, bei denen Markenfeldträger und Substrathalter unterschiedliche Bauteil beziehungsweise Baugruppen darstellen, können die Fixierelemente sich entweder auf dem Substrathalter und/oder dem Markenfeldträger befinden. Befinden sich Fixierelemente auf dem Markenfeldträger, ist vorzugsweise eine Steuerungs-Verbindung zwischen dem Substrathalter und dem Markenfeldträger vorgesehen, um die Fixierelemente des Markenfeldträgers zu steuern.

Die Fixierelemente dienen dem Festhalten der Substrate. Bei den Fixierelementen kann es sich um eines oder mehrere der folgenden Fixierelemente handeln:

- Mechanische Fixiermittel, insbesondere Klemmen
- Vakuumfixiermittel, insbesondere mit einzeln ansteuerbaren oder miteinander verbundenen Vakuumbahnen

- Elektrische Fixiermittel, insbesondere elektrostatische Fixiermittel
- Magnetische Fixiermittel
- Adhäsive Fixiermittel, insbesondere Gel-Pak Fixiermittel
- Fixiermittel mit adhäsiven, insbesondere ansteuerbaren, Oberflächen,

Die Fixiermittel sind, insbesondere elektronisch, ansteuerbar. Die Vakuumfixierung ist die bevorzugte Fixierungsart. Die Vakuumfixierung besteht vorzugsweise aus mehreren Vakuumbahnen, die an der Oberfläche des Probenhalters austreten. Die Vakuumbahnen sind vorzugsweise einzeln ansteuerbar. In einer technisch eher realisierbaren Anwendung sind einige Vakuumbahnen zu Vakuumbahnsegmenten vereint, die einzeln ansteuerbar sind und somit unabhängig voneinander evakuiert oder geflutet werden können. Die Vakuumsegmente sind vorzugsweise ringförmig konstruiert.

Eine besondere Form der Fixierung erfolgt mit Hilfe eines Niedrigkontaktsubstrathalters (engl.: low contact chuck), der aus mehreren einzelnen, insbesondere symmetrisch verteilten, Erhebungen (engl.: pins) besteht. Der Substrathalter wird auch als Noppenprobenhalter (engl.: pin chuck) bezeichnet. Der Raum zwischen den Erhebungen kann evakuiert werden und fungiert dabei gleichzeitig als Vakuumfixierung. Vorteilhaft ist, dass das Substrat nur von den Erhebungen kontaktiert wird und somit eine geringere Beaufschlagung und Kontamination der Substratseite erfolgt, die fixiert wird. Ein weiterer Vorteil besteht darin, dass ein Niedrigkontaktsubstrathalter das fixierte Substrat möglichst wenig verzerrt, was ein Vorteil für eine Vermessung der Strukturen des Substrats ist. Ein weiterer Vorteil besteht darin, dass ein Niedrigkontaktsubstrathalter eine viel gleichmäßigere Fixierung des Substrats erlaubt. Ausführungsformen eines solchen Substrathalters sind in der WO2015113641A1 offenbart, auf die insofern Bezug genommen wird. Ein solcher Niedrigkontaktsubstrathalter ist vorzugsweise zumindest überwiegend intransparent, sodass das erfindungsgemäße Markenfeld sich auf der von der Substratfixieroberfläche abgewandten Oberfläche befindet.

In einer weiteren, weniger bevorzugten erfindungsgemäßen Ausführungsform ist das Substrat, auf dem sich die zu vermessenden Strukturen befinden, selbst der Markenfeldträger. Das Markenfeld wird auf der Substratoberfläche, welcher der Substratoberfläche mit den zu vermessenden Strukturen gegenüberliegt, angeordnet. Diese nicht bevorzugte Ausführungsform hat folgende Nachteile: Erstens muss ein Markenfeld für jedes Substrat erzeugt werden, was zusätzlichen Aufwand und Kosten bringt. Zweitens führt die Erzeugung von Strukturen auf der einen und Marken auf der anderen Seite des Substrats zu Produktionsproblemen und eventuell zu Verzerrungen. Drittens verfügen die Substrate im Regelfall über geringe Biegewiderstände, was ebenfalls zu einer Verzerrung des Markenfeldes führen kann.

Gemäß einer Weiterbildung der vorliegenden Erfindung ist es daher von Vorteil, das Markenfeld vorzugsweise streng vom zu untersuchenden Substrat zu trennen, also das Markenfeld nicht auf dem Substrat selbst anzuordnen.

**Vorrichtung**

Die erfindungsgemäße Vorrichtung besteht aus einem Markenfeldträger, einem Substrathalter und mindestens zwei Optiken. Der Markenfeldträger ist vorzugsweise Teil eines Substrathalters oder umgekehrt. Soweit in der vorliegenden Beschreibung vom Substrathalter oder Markenfeldträger die Rede ist, werden diese als Einheit betrachtet oder synonym verwendet.

Die beiden Optiken sind so konstruiert und angeordnet, dass sie aufeinander zu gerichtet sind. Die optischen Achsen der beiden Optiken werden vorzugsweise so gut wie möglich zueinander kalibriert, vorzugsweise parallel oder fluchtend ausgerichtet. In Bezug auf die Kalibrierung zweier zueinander ausgerichteter Optiken wird auf die Offenbarung der Druckschrift WO2014202106A1 Bezug genommen. Die Optiken können in x- und/oder y- und/oder z-Richtung translatorisch bewegt und/oder, vorzugsweise um drei jeweils senkrecht zueinander angeordnete Raumachsen, gedreht werden. Die Freiheitsgrade dienen der Kalibration der Optiken. Sind beide Optiken zueinander kalibriert worden, erfolgt vorzugsweise keine Relativbewegung mehr zwischen den Optiken. Die Optiken werden während der erfindungsgemäßen Bestimmung der X-Y-Positionen relativ zueinander fixiert.

Der Vollständigkeit halber wird die Möglichkeit der gekoppelten Bewegung zweier zueinander kalibrierte Optiken offenbart. Vorzugsweise sind die Optiken über eine Art U-förmige Verbindung mechanisch miteinander gekoppelt, so dass die Optiken auch hier während der erfindungsgemäßen Bestimmung der X-Y-Positionen relativ zueinander fixiert sind. Bevorzugter ist allerdings die mechanische Trennung beider Optiken voneinander. Vorzugsweise sind die Optiken von dem Gestell beziehungsweise der Oberfläche, auf dem/der der Substrathalter bewegt wird, mechanisch bestmöglich entkoppelt beziehungsweise zumindest gedämpft, um Schwingungen zu minimieren.

Das Gestell ist vorzugsweise von den Optiken mechanisch getrennt beziehungsweise zumindest gedämpft, um eine Schwingungsübertragung möglichst vollständig zu vermeiden.

**Verfahren**

Vor den entscheidenden erfindungsgemäßen Verfahrensschritten der Bestimmung der X-Y-Positionen werden die beiden Optiken insbesondere zueinander bestmöglich kalibriert.

In einem optimalen Kalibrierverfahren werden die optischen Achsen der beiden Optiken zueinander kongruent, also deckungsgleich, ausgerichtet.

Dieser Zustand ist technisch schwer bis gar nicht zu erreichen. Vorzugsweise sollte aber zumindest versucht werden, sich diesem Zustand bestmöglich anzunähern.

Ein weiterer wichtiger Schritt für eine optimale Kalibrierung der beiden Optiken zueinander besteht darin, die Schärfentiefebereiche beider Optiken so zu überlagern, dass der Schnittbereich der Schärfentiefebereiche das Markenfeld und die zu vermessenden Strukturen gleichzeitig erfasst. Das ist nur dann möglich, wenn beide Schärfentiefebereiche zumindest so groß oder größer sind als der Abstand zwischen dem Markenfeld und den zu vermessenden Strukturen, was hiermit als vorteilhafte Ausführungsform der Erfindung offenbart wird. Insbesondere bei dicken Substraten oder bei Markenfeldträgeren, bei denen sich das Markenfeld weit von den zu vermessenden Strukturen entfernt befindet, wird das Markenfeld von der einen Optik und werden die Strukturen von der anderen Optik fokussiert, d.h. in den jeweiligen Schärfentiefebereich der jeweiligen Optik gebracht.

Vor dem eigentlichen erfindungsgemäßen Verfahren wird vorzugsweise eine Kalibrierung der beiden Optiken zueinander vorgenommen, um etwaige Fehler, die durch eine Schrägstellung der beiden Achsen zustande kommen können, bei der Bestimmung der X-Y-Positionen berücksichtigen zu können.

Erfindungsgemäß bevorzugt ist die Herstellung eines Markenfeldträgers mit einem möglichst vielschichtig einsetzbaren Markenfeld, das für alle Arten von Strukturen möglichst beliebiger Substrate verwendet werden kann. Das ist insbesondere auch im Hinblick auf die hohen Herstellungskosten für einen solchen Markenfeldträger wünschenswert. Bevorzugt ist somit ein möglichst unabhängig von den zu erfassenden Strukturen des Substrats ausgebildetes Markenfeld.

In einer besonderen erfindungsgemäßen Ausführungsform können einer Lagemarke mehrere Positionsmarken zugeordnet sein, sodass man ein sehr dichtes Feld an Positionsmarken erhält. Alternativ oder zusätzlich dazu werden insbesondere mehrere Positionsmarken im Sichtbereich der Optik angeordnet. Der Sichtbereich ist vorzugsweise rechteckig, am bevorzugtesten quadratisch, d.h. die Anzahl der Bildpunkte pro Sichtbereichsdimension ist konstant. Die Anzahl der Positionsmarken pro Sichtbereichsdimension ist dabei mindestens 1, vorzugsweise größer als 3, noch bevorzugter größer als 5, am bevorzugtesten größer als 7, am allerbevorzugtesten größer als 10. Durch eine erfindungsgemäß hohe Anzahl von Positionsmarken wird sichergestellt, dass immer zumindest eine (vorzugsweise zumindest zwei) Positionsmarke(n) im Sichtbereich zu finden ist (sind), auch wenn die nächste Lagemarke noch nicht sichtbar ist. Die Dichte der Positionsmarken kann daher insbesondere größer sein als die Dichte der Lagemarken. Die Dichte der Positionsmarken ist gleich, vorzugsweise 2 mal, noch bevorzugter 5 mal, am bevorzugtesten 10 mal, am allerbevorzugtesten 100 mal so groß wie die Dichte der Lagemarken.

Insbesondere erlauben erfindungsgemäße Verfahren und Ausführungsformen, bei denen sich mehrere Positionsmarken gleichzeitig im Sichtbereich befinden eine Mittelung der Positionsmarken, bei denen vorzugsweise Herstellungsfehler der Positionsmarken ausgeglichen werden. Durch die Mittelung erhält man entsprechend gemittelte, imaginäre Positionsmarken, die dann als Positionsmarken für die Vermessung der Strukturen an der Substratoberfläche verwendet werden können. Angenommen, es befinden sich vier Positionsmarken gleichzeitig im Sichtbereich, die sich alle an den Ecken eines Quadrats befinden. Durch die Ermittlung der Positionen der Positionsmarken kann das Zentrum des Quadrats berechnet werden, welches als neue Positionsmarke dient. Diese neue Positionsmarke existiert zwar nicht physisch, kann aber von einem Computer ermittelt und gespeichert und falls nötig auch in einem digitalen Bild eingezeichnet werden. Für das erfindungsgemäße Verfahren ist es dann irrelevant, ob eine physisch vorhandene oder eine berechnete Positionsmarke für das erfindungsgemäße Verfahren verwendet wird.

Das erfindungsgemäße Verfahren kann insbesondere verwendet werden, um die Abweichung zwischen einem Ist-Parameter und einem Soll-Parameter einer Struktur oder mindestens eines Strukturmerkmals einer Struktur an einer Substratoberfläche (also insbesondere Produktionsfehler) zu ermitteln. Denkbare Produktionsfehler wären, dass photolithographische Prozesse eine leicht schräge Belichtung durchführen, Ätzprozesse die Kanten verfälschen etc. Außerdem kann es sich bei den Abweichungen um nachträgliche Verzerrungen, insbesondere durch Temperaturschwankungen, handeln. Insbesondere können die Strukturen einen

- Rotationsfehler und/oder
- Translationsfehler und/oder
- Skalierungsfehler und/oder
- Restfehler

besitzen. Unter Rotationsfehler versteht man einen Fehler, bei dem die Strukturen eine globale und/oder lokale Rotation in Bezug zu ihren idealen Soll-Positionen erfahren haben. Unter Translationsfehler versteht man einen Fehler, bei dem die Strukturen eine globale und/oder lokale Translation in Bezug zu ihren idealen Soll-Positionen erfahren haben. Unter Skalierungsfehler versteht man einen Fehler, bei dem die Strukturen eine globale und/oder lokale Skalierung in Bezug zu ihren idealen Soll-Positionen erfahren haben. Dieser Fehler wird in der Fachwelt auch als "run-out" bezeichnet. Er zeichnet sich insbesondere dadurch aus, dass der Fehler mit zunehmendem Radius größer wird. Meistens ist dieser Fehler ein Resultat einer thermischen Dehnung, die am Rand eines Substrats stärker wirkt als im zentrumsnahen Bereich. Mit Restfehler werden alle anderen Arten von Fehlern bezeichnet, welche zu einer Abweichung der Ist-Struktur von der Soll-Struktur führen. Der Effekt, dass sich die Ist-Strukturen von den Soll-Strukturen leicht unterscheiden, wird im Weiteren als Anfangsfehler oder "incoming error" bezeichnet.

Andere oder zusätzliche Fehler können während eines nachfolgenden Prozesses, insbesondere eines Bondprozesses, entstehen. Die erfindungsgemäße Ausführungsform ist vor allem dazu geeignet, Strukturen zu vermessen, bevor ein weiterer Prozess, insbesondere ein Bondprozess, stattfindet. Die Vermessung des Ist-Zustandes der Strukturen, insbesondere kurz vor einem Bondvorgang, ist von fundamentaler Bedeutung, um die Deckungsgleichheit von Strukturen zweier zu bondender Substrate zu gewährleisten und sicherzustellen. Der Vollständigkeit halber wird allerdings erwähnt, dass man mit der erfindungsgemäßen Methode auch eine Vermessung von Strukturen in Relation zum erfindungsgemäßen Markenfeld durchführen kann, nachdem ein Bondvorgang erfolgt ist. Dazu müsste dann das Substrat, durch welches man die Strukturen untersucht, transparent für die jeweils verwendete elektromagnetische Strahlung sein um die Strukturen in der Bondgrenzfläche erkennen zu können. Denkbar wäre die Verwendung von Glassubstraten. Denkbar wäre auch, dass das entsprechende Substrat infrarot transparent ist und man Infrarotstrahlung zur Vermessung der Strukturen verwendet. Denkbar wäre auch, dass das Substrat so dünn ausgeführt ist, dass es ausreichend transparent für sichtbares Licht ist. Für Silizium wäre das bei Dicken von weniger als $10\,\mu m$, vorzugsweise weniger als $5\,\mu m$, noch bevorzugt weniger als $3\,\mu m$, am bevorzugtesten weniger asl $2\,\mu m$, am allerbevorzugtesten weniger als $1\,\mu m$ der Fall.

Als eigenständige Erfindung wird daher auch ein Verfahren zur Bestimmung der X-Y-Positionen der Strukturen/Strukturmerkmale von zwei in einem erfindungsgemäß anschließenden Bondschritt zu verbindenden Substraten offenbart.

In einem optionalen Verfahrensschritt werden die optischen Achsen der zwei verwendeten Optiken zueinander kalibriert. Die Kalibrierung der beiden Optiken erfolgt vorzugsweise mit einem Kalibriersubstrat.

Das Kalibriersubstrat besitzt eine Dicke, die ungefähr dem Abstand zwischen den zu vermessenden Strukturen am Substrat und dem Markenfeld entspricht. Das Kalibriersubstrat weist zwei Kalibriermarken auf, eine auf jeder Seite. Diese beiden Kalibriermarken müssen bestmöglich zueinander korreliert sein, d.h. direkt übereinander liegen. Anders ausgedrückt, sollte die laterale Verschiebung zwischen den beiden Kalibriermarken minimal sein. In einer besonders bevorzugten erfindungsgemäßen Ausführungsform erzeugt man derartige Kalibriermarken, indem man einen Durchgang, insbesondere eine durchgehende Bohrung, noch bevorzugter eine durchgehende Ätzung, von einer Substratoberfläche zur anderen Substratoberfläche erzeugt. Die Löcher an den Substratoberflächen sind dann über die Dicke deckungsgleich zueinander. Diese Methode wird im weiteren Verlauf als Lochmethode bezeichnet.

In einem ersten erfindungsgemäßen Kalibrierverfahren fokussiert die obere Optik die obere Kalibriermarke und die untere Optik die untere Kalibriermarke. Da die optischen Achsen der beiden Optiken im Allgemeinen nicht kongruent zueinander sind, sind auch die beiden, in einem Bild vereinigten, Kalibriermarken nicht deckungsgleich. Die Abstände in dx1 und dy1 in x- und y-Richtung zwischen den Kalibriermarken werden vermessen und gespeichert.

Danach erfolgt eine 180° Drehung des Substrats und eine erneute Vermessung der Kalibriermarken. Die Abstände in dx2 und dy2 in x- und y-Richtung zwischen den Kalibriermarken werden vermessen und gespeichert.

In einem weiteren Kalibrierschritt wird der Fehlerwert dx und dy berechnet.

- $$dx = dx1 + dx2$$

- $$dy = dy1 + dy2$$

Die so ermittelten Werte dx und dy sind nun die (doppelten) Summenfehler, bestehend aus der (doppelten) laterale Verschiebung der Kalibriermarken und dem (doppelten) optischen Fehler.

- dx=(doppelte) laterale Verschiebung x + (doppelte) optischer Fehler x
- dy=(doppelte) laterale Verschiebung y + (doppelte) optischer Fehler y Durch die bereits erwähnte Verwendung optimaler Herstellmethoden für die Kalibriermarken, insbesondere die Lochmethode, kann die laterale Verschiebung praktisch auf null reduziert werden und die Werte dx und dy stellen den (doppelten) optischen Fehler dar.
- (doppelte) optischer Fehler x=dx
- (doppelte) optischer Fehler y=dy

Für den Fall, dass die lateralen Verschiebungen nicht verschwindend gering sind, müssen diese mit anderen Methoden ermittelt und dann abgezogen werden.

- (doppelte) optischer Fehler x=dx-gemessene(doppelte) laterale Verschiebung x
- (doppelte) optischer Fehler y= dy-gemessene(doppelte) laterale Verschiebung y

Der optische Fehler in x- und y-Richtung ergibt sich schließlich durch

- optischer Fehler x=(doppelte) optischer Fehler x/2
- optischer Fehler y=(doppelte) optischer Fehler y/2

Der optische Fehler in x- und y-Richtung muss nur einmal berechnet werden, solange die Optiken danach nicht mehr zueinander bewegt werden. Danach kann der optische Fehler in x- und y-Richtung herangezogen werden, um jeden vermessenen Abstand in x- und y-Richtung zwischen der Struktur an der Substratoberfläche und der entsprechenden Positionsmarke im Markenfeld um den optischen Fehler zu korrigieren. Der optische Fehler wird vorzugsweise als Vektor gespeichert und im weiteren Verlauf des Textes mit dem Buchstaben F bezeichnet.

In einem weiteren erfindungsgemäßen Verfahrensschritt wird ein Substrat auf den Substrathalter und den Markenfeldträger mit dem Markenfeld fixiert. Vorzugsweise sind Substrat und Markenfeldträger zwei separate Bauteile. Insbesondere wird das Substrat direkt am Markenfeldträger fixiert, der wiederum am Substrathalter fixiert ist.

In einem anschließenden erfindungsgemäßen Verfahrensschritt werden Strukturen, insbesondere alle Strukturen, auf der Substratoberfläche angefahren und vermessen. Während die erste, insbesondere obere Optik eine Struktur des Substrats im Sichtbereich hat, nimmt die zweite, insbesondere untere Optik, den korrespondierenden Bereich mit mindestens einer Lagemarke und mindestens einer Positionsmarke des Markenfeldes auf. Die beiden erzeugten Bilder können digital übereinandergelegt werden und ergeben so ein, vorzugsweise digital mittels einer Software, auswertbares Überlagerungsbild.

Sobald eine Lagemarke im Sichtbereich der unteren Optik liegt, wird die Information zum X-Y-Koordinatenbereich der Lagemarke ausgewertet. Somit ist der Vorrichtung nunmehr bekannt, an welcher Grobposition sich der Substrathalter und damit das Substrat gegenüber den Optiken befindet. Vorzugsweise wird die Positionsmarke gegenüber der unteren Optik zentriert, sodass sie sich im Zentrum des Sichtbereichs befindet. Alternativ kann die Optik gegenüber einem charakteristischen Strukturmerkmal der Struktur, die vermessen werden soll, zentriert werden. Da vorzugsweise mehrere charakteristische Strukturmerkmale der Struktur in Bezug zur Positionsmarke vermessen werden sollen, um auch eine Rotationslage der Struktur bestimmen zu können, wird bevorzugt die Positionsmarke zentriert.

Die Zentrierung der Positionsmarke ist bevorzugt, aber für die Ausführung der Erfindung nicht wesentlich, da bei einer Vermessung der Abstände zwischen der Positionsmarke und den charakteristischen Strukturmerkmalen der Struktur eine absolute Positionierung nicht notwendig ist.

Wichtig ist vor allem, dass mindestens ein charakteristisches Strukturmerkmal der Struktur relativ zur Positionsmarke vermessen wird. Beispielsweise kann bei einer rechteckigen Struktur die linke obere Ecke gewählt werden. Bei einer rechteckigen Struktur ist es bevorzugt, alle vier Ecken in Bezug zur Positionsmarke zu vermessen. Unter Vermessung versteht man die Evaluierung mindestens zweier Werte, nämlich einem horizontalabstand dx und einem Vertikalabstand dy, jeweils zur selben Positionsmarke.

Insbesondere werden die Bilder und/oder die ermittelten Daten, insbesondere Lagedaten der Lagemarke sowie Positionsdaten der Positionsmarke und Strukturen bzw. Strukturmerkmale in einem Computer gespeichert.

Dieser Verfahrensschritt wird für eine beliebige Anzahl, vorzugsweise alle Strukturen auf dem Substrat durchgeführt.

In einem weiteren erfindungsgemäßen Verfahrensschritt werden - nachdem die X-Y-Positionsdaten, insbesondere aller, erfassten charakteristischen Strukturmerkmale der Strukturen vorliegen - die bestimmten X-Y-Positionen in Bezug zu der jeweiligen Idealposition (Soll-Position) gesetzt. Als Bezug eignet sich insbesondere eine ideale Struktur, vorzugsweise das Markenfeld. Dadurch sind Abweichungen der charakteristischen Strukturmerkmale, d.h. die Differenz zwischen dem Soll- und der Ist-Zustand, ermittelbar.

Die genaue, insbesondere mathematische, Ermittlung der X-Y-Positionen beziehungsweise Abweichungen erfolgt insbesondere unter Berücksichtigung eines oder mehrerer der nachfolgend aufgeführten Punkte:

- die Achsen des Markenfeldes sind nicht kongruent zu den Achsen des Substratkoordinatensystems,
- die idealen Positionsmarken des Markenfeldes im Computer sind nicht identisch zu den realen Positionsmarken des Markenfeldes am Markenfeldträger angeordnet. Die Abweichungen können vermessen und gespeichert werden,
- die Korrelation zwischen den Positionen der realen Positionsmarken des Markenfeldes und den Positionen der realen Strukturen auf dem Substrat können wie vorliegend beschrieben ermittelt werden,
- die Korrelation zwischen den Positionen der idealen Positionsmarken des Markenfeldes im Computer und den Positionen der idealen Strukturen im Computer kann berechnet werden, da die Daten immer zur Verfügung stehen und nicht erst vermessen werden müssen,
- der optische Fehler kann durch die im Kalibrierprozess ermittelten Werte aus den Daten herausgerechnet werden,
- die Daten aus der oberen Aufzählung erlauben immer die Berechnung der Abweichung der realen Strukturen auf dem Substrat von den idealen Strukturen im Computer.

In einem Prozessschritt wird insbesondere die Achsenorientierung des Markenfeldkoordinatensystems relativ zum Substratkoordinatensystem ermittelt. Insbesondere erfolgt eine Korrektur durch eine Relativverschiebung zwischen dem Substrat und dem Markenfeldträger, insbesondere durch aktive Bewegung des Substrats.

Da nach einer Fixierung des Substrats am Markenfeldträger eine neuerliche Bewegung des Substrats allerdings nicht von Vorteil ist, wird die Korrelation zwischen den beiden Koordinatensystemen insbesondere mathematisch ermittelt. Durch die Messung mehrerer Positionsmarken am Markenfeldträger, insbesondere entlang zweier zueinander senkrechter Richtungen, können die Achsenrichtungen ermittelt werden.

Analoge Überlegungen gelten für die Achsen des Substrats. Aus diesen Daten lässt sich eine Rotationsmatrix R berechnen. Die Verschiebung zwischen den beiden Koordinatenursprüngen wird insbesondere durch einen Vektor v beschrieben. Damit ergibt sich, dass der Korrekturterm für die Korrelation zwischen den Positionsmarken am Markenfeldträger und den Strukturen am Substrat durch die Gleichung $x_{Substrat}=R*x_{Markenfeld}+v$ beschrieben werden kann. Die entsprechende inverse Darstellung lautet $x_{Markenfeld}=R^{-1}*x_{Substrat}-v$ Der Fachmann auf dem Gebiet kennt die notwendige Matrixalgebra.

Da für diesen Prozessschritt mehrere Positionsmarken des Markenfeldes bzw. mehrere Strukturen am Substrat vermessen werden, ist der Prozessschritt nicht ohne weiteres zeitlich eindeutig zuordenbar. Die Korrelation zwischen den beiden Koordinatensystemen kann umso genauer durchgeführt werden, je mehr Daten vorliegen. Vorzugsweise werden für die Ermittlung der Rotationsmatrix und des Verschiebungsvektors mathematische Algorithmen verwendet, die auf der Methode der kleinsten Quadrate basieren. Im weiteren Verlauf des Textes wird davon ausgegangen, dass die Achsenorientierung aller beteiligten Koordinatensysteme immer denselben Ursprung und dieselbe Orientierung zueinander haben.

Für die Beschreibung des mathematischen Berechnungsprozesses wird folgende Konvention verwendet. Der Index i steht für ideal, der Index r steht für real, der Index S steht für Struktur und der Index M steht für Marke. Ein Differenzenvektor wird immer mit dem Kleinbuchstaben r bezeichnet. Der Differenzenvektor wird insbesondere aus einem Positionsvektor berechnet, der zum Endpunkt zeigt, weniger aus dem Positionsvektor, der zum Anfangspunkt zeigt. Entsprechend wird der Index des Endpunktes zuerst notiert, wie es mathematische Konvention ist. Die Positionsvektoren werden in den weiter unten beschriebenen und gezeigten Figuren nicht eingezeichnet. Als Beispiel wird der erfindungsgemäß zu berechnende Vektor $r_{Sr,Si}$ genannt. Es handelt sich um den Differenzenvektor, der die Abweichung der Position zwischen der realen Struktur und der idealen Struktur beschreibt.

In einem weiteren Prozessschritt werden die Positionen der idealen Positionsmarken eines Markenfeldes im Computer mit den Positionen der realen Positionsmarken des Markenfeldes am Markenfeldträger verglichen. Durch diese Vermessung erhält man eine Tabelle, in der die realen Positionen der Positionsmarken und/oder die idealen Positionen der Positionsmarken und/oder deren Differenzvektoren im Computer gespeichert werden. Die Differenzvektoren werden als $r_{Mr,Mi}$ bezeichnet. Die so ermittelten Differenzvektoren ergeben eine Vektorkarte, die im weiteren Verlauf des Textes als Markenfeldfehlervektorkarte bezeichnet wird.

In einem weiteren Prozessschritt werden die Positionen der realen Positionsmarken eines Markenfeldes am Markenfeldträger mit den Positionen der Strukturen am Substrat verglichen. Durch die Vermessung der realen Positionen der Positionsmarken des Markenfeldes und der Positionen der Strukturen am Substrat erhält man eine Tabelle, in der die realen Positionen der Positionsmarken und/oder die Positionen der Strukturen am Substrat und/oder die Differenzvektoren im Computer gespeichert werden. Die Differenzvektoren werden als $r_{Sr,Mr}$ bezeichnet. Die so ermittelten Differenzen ergeben eine Vektorkarte, die im weiteren Verlauf des Textes als reale Markenstrukturdifferenzvektorkarte bezeichnet wird. Das ist der Prozessschritt, der einen Kerngedanken der Erfindung ausmacht, nämlich die Assoziation der Positionsmarken eines Markenfeldträgers mit den Strukturen eines Substrats.

In einem weiteren Prozessschritt werden die Positionen der idealen Positionsmarken eines Markenfeldes im Computer mit den idealen Positionen der Strukturen im Computer verglichen. Durch die Auslesung der idealen Positionen der Positionsmarken des Markenfeldes im Computer und der idealen Positionen der Strukturen im Computer erhält man eine Tabelle, in der die idealen Positionen der Positionsmarken im Computer und/oder die idealen Positionen der Strukturen im Computer und/oder die Differenzvektoren im Computer gespeichert werden. Die Differenzvektoren werden als $r_{Si,Mi}$ bezeichnet. Die so ermittelten Differenzen ergeben eine Vektorkarte, die im weiteren Verlauf des Textes als ideale Markenstrukturdifferenzvektorkarte bezeichnet wird. Insbesondere muss dieser Prozessschritt für jede Kombination eines idealen Markenfeldes und eines idealen Strukturfeldes nur einmal durchgeführt werden.

Als Resultat ergibt sich dann $r_{Sr,Si}= r_{Mr,Mi}+ r_{Sr,Mr}-r_{Si,Mi}-F$, wobei F der im Kalibrierungsprozess berechnete Vektor des optischen Fehlers ist. Vorzugsweise ist F für alle Punkte konstant, d.h. F stellt kein Vektorfeld, sondern eine Konstante als Funktion des Ortes dar.

Eine mehrfache Vermessung ist erfindungsgemäß denkbar, um durch statistische Mittel die Qualität der Messung zu erhöhen. Die erneute Vermessung ist durch die vorhandenen Daten und Lage der Lagemarken schnell durchführbar. Am schnellsten geht die Erfassung, wenn die Erfassung Schritt für Schritt von Marke zu Marke erfolgt. Die Verwendung eines Messsystems, welches die absolute Position des Substrathalters bzw. die relative Verschiebung des Substrathalters, insbesondere kontinuierlich, mitverfolgt, ist somit überflüssig.

In einem weiteren, optionalen aber besonders erwünschten erfindungsgemäßen Verfahrensschritt erfolgt eine Drehung des Substrats, insbesondere um exakt 180°, um alle vorher vermessen Strukturen erneut zu vermessen. Das Auffinden der Strukturen ist schnell durchführbar, da die Strukturen im vorherigen Erfassungsschritt bereits mit den positionskodierten Lagemarken assoziiert wurden. Durch die Verwendung von Algorithmen kann ein etwaiger optischer Fehler, der durch eine etwaige Schrägstellung der optischen Achsen der Optiken entstanden ist, korrigiert werden.

Es werden alle technisch möglichen Kombinationen und/oder Permutationen sowie Vervielfachungen der funktionellen und/oder materiellen Teile der Vorrichtung und die damit einhergehenden Veränderungen in mindestens einem der Verfahrensschritte oder Verfahren als offenbart betrachtet.

Soweit vorliegend und/oder in der anschließenden Figurenbeschreibung Vorrichtungsmerkmale offenbart sind, sollen diese auch als Verfahrensmerkmale offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:

Figur 1a    eine Detailansicht einer ersten Ausführungsform einer erfindungsgemäßen Marke mit einer Lagemarke und einer Positionsmarke,

Figur 1b    eine Detailansicht einer zweiten Ausführungsform einer erfindungsgemäßen Marke mit einer Lagemarke und einer Positionsmarke,

Figur 2    eine Aufsicht und eine Schnittansicht gemäß Schnittlinie A-A einer Ausführungsform eines erfindungsgemäßen Markenfeldträgers mit einem Markenfeld,

Figur 3    eine Aufsicht und eine Schnittansicht gemäß Schnittlinie A-A einer Ausführungsform eines erfindungsgemäßen Substrathalters in einer ersten Ausführungsform,

Figur 4    eine Aufsicht und eine Schnittansicht gemäß Schnittlinie A-A einer Ausführungsform eines erfindungsgemäßen Substrathalters in einer zweiten Ausführungsform,

Figur 5    eine Aufsicht und eine Schnittansicht gemäß Schnittlinie A-A einer Ausführungsform eines erfindungsgemäßen Substrathalters in einer dritten Ausführungsform,

Figur 6    eine Aufsicht und eine Schnittansicht gemäß Schnittlinie A-A einer Ausführungsform eines erfindungsgemäßen Substrathalters in einer vierten Ausführungsform,

Figur 7    eine Aufsicht und eine Schnittansicht eines erfindungsgemäßen Substrats mit Strukturen und einem Markenfeld,

Figur 8    eine seitliche Schnittansicht einer Ausführungsform der erfindungsgemäßen Vorrichtung in einem erfindungsgemäßen Verfahrensschritt der Erfassung,

Figur 9    eine Teilseitenansicht eines Erfassungsschrittes,

Figur 10    eine Teilseitenansicht eines Erfassungsschrittes,

Figur 11    eine Teilseitenansicht eines Erfassungsschrittes,

Figur 12    eine Teilseitenansicht eines Erfassungsschrittes,

Figur 13    eine Teilseitenansicht eines Erfassungsschrittes,

Figur 14a    ein aus einem Erfassungsschritt erzeugtes Überlagerungsbild an einer ersten Position in einer ersten Rotationslage,

Figur 14b    ein aus einem Erfassungsschritt erzeugtes Überlagerungsbild an der ersten Position in einer zweiten Rotationslage

Figur 15a    ein aus einem Erfassungsschritt erzeugtes Überlagerungsbild an einer zweiten Position in einer ersten Rotationslage

Figur 15b    ein aus einem Erfassungsschritt erzeugtes Überlagerungsbild an der zweiten Position in einer zweiten Rotationslage

Figur 16    ein erfindungsgemäß erzeugtes Vektorfeld zur Darstellung von erfindungsgemäß ermittelten Abweichungen und

Figur 17    eine Darstellung der auftretenden Differenzenvektoren.

In den Figuren sind gleiche Bauteile oder Bauteile mit der gleichen Funktion mit den gleichen Bezugszeichen gekennzeichnet.

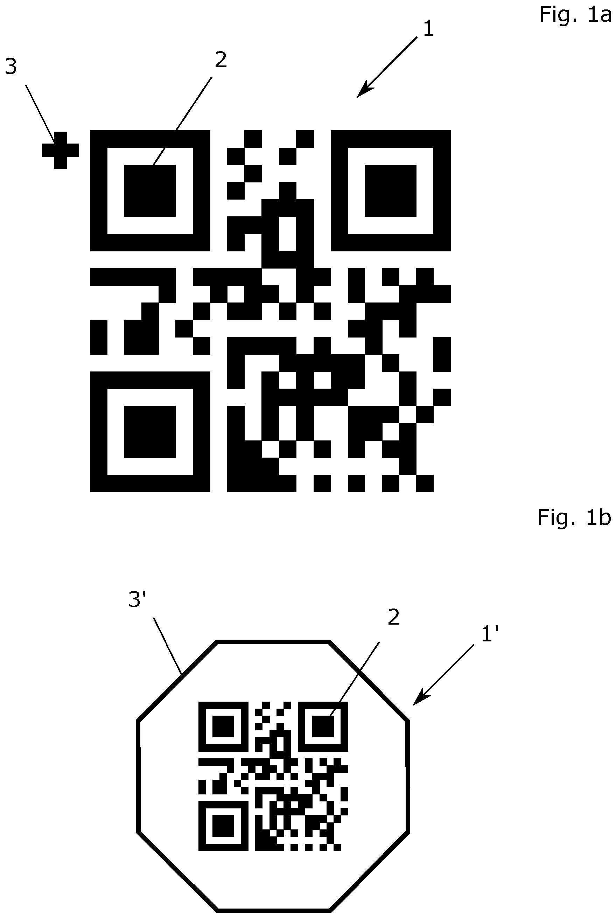

Die Figur 1a zeigt eine Marke 1, bestehend aus einer Lagemarke 2, insbesondere einem QR Code, und einer Positionsmarke 3. In einer besonders bevorzugten erfindungsgemäßen Ausführungsform wird die Lagemarke 2 auch als Positionsmarke verwendet, so dass die Positionsmarke 3 wegfällt und in der Lagemarke 2 enthalten wäre.

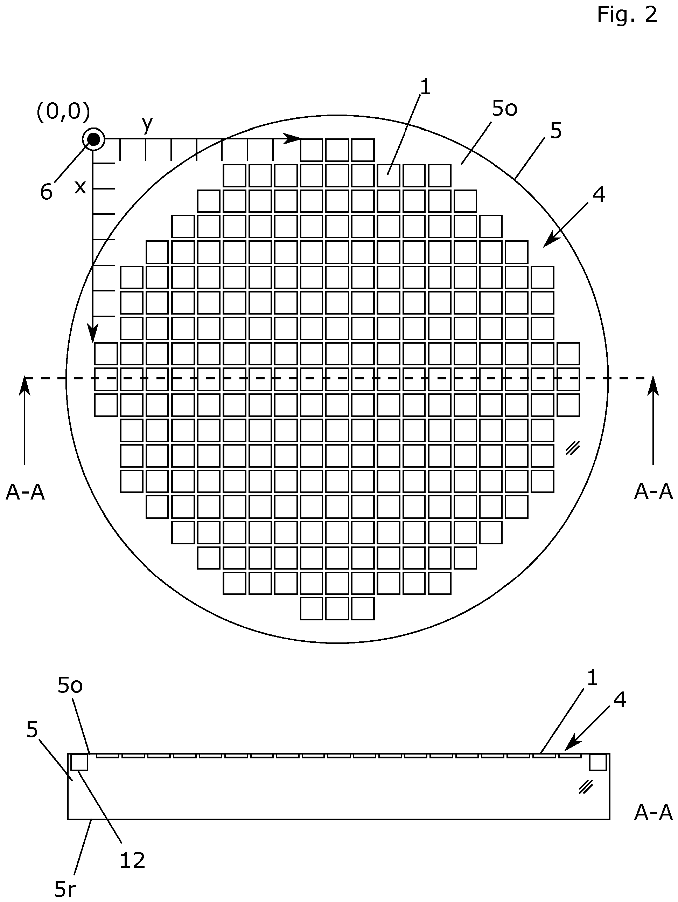

Die Lagemarke 2 ist so konstruiert, dass ein, insbesondere optisches, System in der Lage ist, Informationen auszulesen. Der exemplarische QR-Code enthält die auslesbare Positionsinformation (1,11). Hieraus ergibt sich, dass sich diese Lagemarke in der ersten Zeile und der elften Spalte eines Rasters eines in Figur 2 gezeigten Markenfelds 4 befindet.

Die Figur 1b zeigt eine besonders bevorzugte Marke 1' bestehend aus einer Lagemarke 2, insbesondere einem QR Code, und einer Positionsmarke 3'. Die Lagemarke 2 ist in dieser speziellen Ausführungsform kleiner als die Positionsmarke 3' und wird von der Positionsmarke 3', insbesondere vollumfänglich, umschlossen. Ein Auswertealgorithmus ist in der Lage, die Form bzw. Kontur der Positionsmarke 3' zu erkennen und eine exakte Position der Positionsmarke 3' zu bestimmen. Im konkreten Fall wäre die exakte Position das Zentrum des Oktagons. Das Zentrum des Oktagons könnte beispielsweise von einer Software dadurch gefunden werden, dass ein Algorithmus ein mathematisches Oktagon an die Kontur des Oktagons aus dem vermessenen Bild anpasst und aus dem mathematischen Oktagon das Zentrum bestimmt. Derartige Algorithmen sind dem Fachmann bekannt und sollen hier nicht weiter ausgeführt werden.

In den weiteren Figurenbeschreibungen wird die Marke 1 gemäß Figur 1a exemplarisch zur weiteren Veranschaulichen des erfindungsgemäßen Konzepts verwendet.

Die Figur 2 zeigt eine Aufsicht und eine Seitenansicht eines Markenfeldträgers 5 mit dem Markenfeld 4, bestehend aus mehreren, insbesondere hochsymmetrisch zueinander angelegten, Marken 1. Die Marke 1 gemäß Figur 1a befindet sich an der Rasterposition (1, 11), da sie sich in Bezug zum gezeigten Ursprung eines auf den Markenfeldträger 5 bezogenen Koordinatensystems 6 in der ersten Zeile und der elften Spalte befindet. Die Zählung beginnt bei hier null.

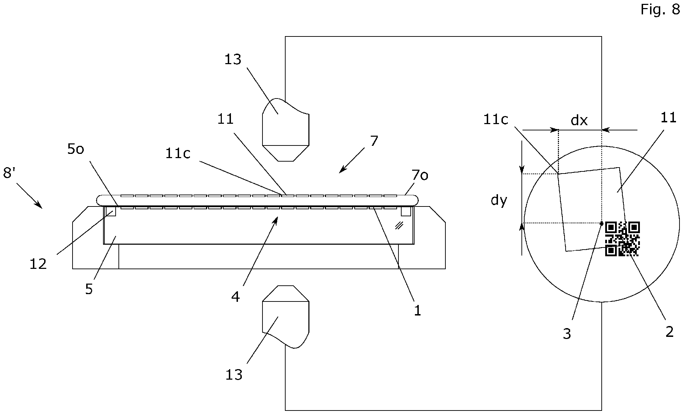

Das Markenfeld 4 befindet sich vorzugsweise auf einer Markenfeldträgeroberfläche 5o des Markenfeldträgers 5. Der Markenfeldträger 5 ist vorzugsweise durchsichtig, sodass das Markenfeld 4 von einer Markenfeldträgerrückseite 5r aus durch den Markenfeldträger 5 hindurch erfasst werden kann. Der Markenfeldträger 5 besitzt vorzugsweise Fixiermittel 12 in Form von Vakuumbahnen, mit deren Hilfe ein Substrat 7 (siehe Figur 8) fixiert werden kann.

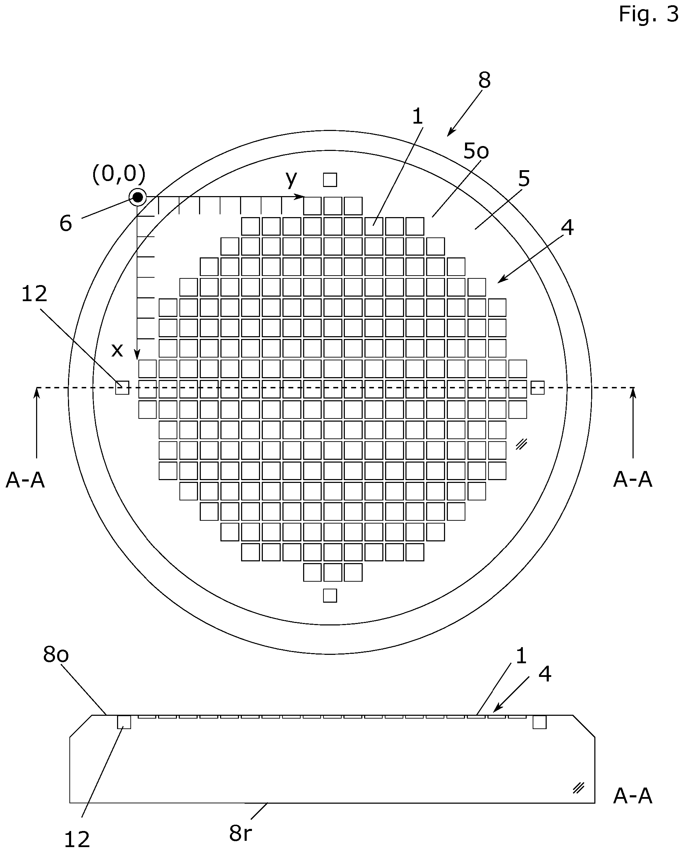

Die Figur 3 zeigt eine erste Ausführungsform eines, insbesondere transparenten, Substrathalters 8, der gleichzeitig als Markenfeldträger 5 ausgebildet ist. Das Markenfeld 4 befindet sich dann vorzugsweise an derselben Substrathalteroberfläche 8o wie die Fixiermittel 12. In einer noch bevorzugteren erfindungsgemäßen Ausführungsform ist der Substrathalter 5 intransparent, wobei das Markenfeld 4 auf der Substrathalterrückseite 8r angeordnet ist.

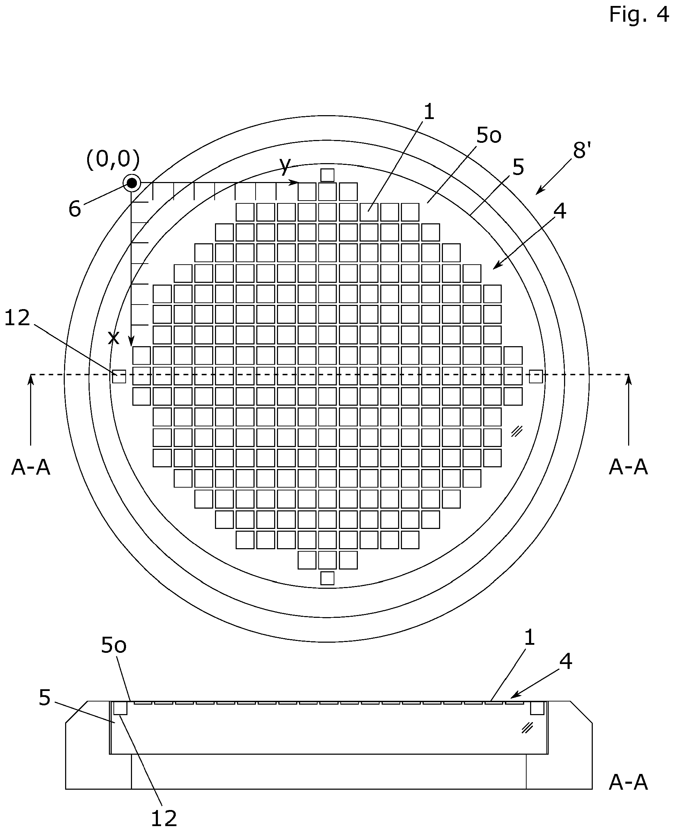

Die Figur 4 zeigt eine zweite Ausführungsform des Substrathalters 8'. Der Substrathalter 8' nimmt den Markenfeldträger 5 auf, ist also im Unterschied zur ersten Ausführungsform nicht selbst der Markenfeldträger. Der Markenfeldträger 5 ist vorzugsweise transparent. Das Markenfeld 4 befindet sich auf derselben Markenfeldträgeroberfläche 5o wie die Fixiermittel 12. Der Markenfeldträger 5 wird zentrisch nicht unterstützt und kann daher, insbesondere auf Grund der Gravitation, aber auch durch eine von oben wirkende Kraft, nach unten durchbiegen. Eine derartige Durchbiegung würde das Markenfeld 4 auf der Markenfeldträgeroberfläche 5o stauchen und ist daher vorzugsweise zu reduzieren. Dies wird durch eine besonders dicke Ausführung des Markenfeldträgers 5 erreicht.

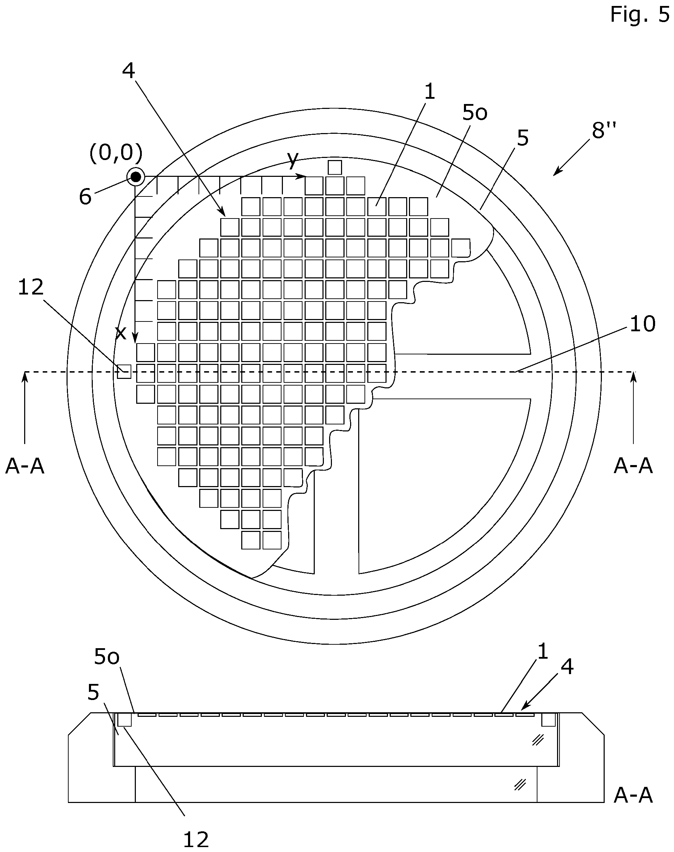

Die Figur 5 zeigt eine dritte, weiter verbesserte Ausführungsform des Substrathalters 8". Der Substrathalter 8" verfügt über Streben 10, die den Markenfeldträger 5 unterstützen, sodass eine Durchbiegung weitestgehend vermieden wird. Vorzugsweise sind die Streben 10 selbst transparent.

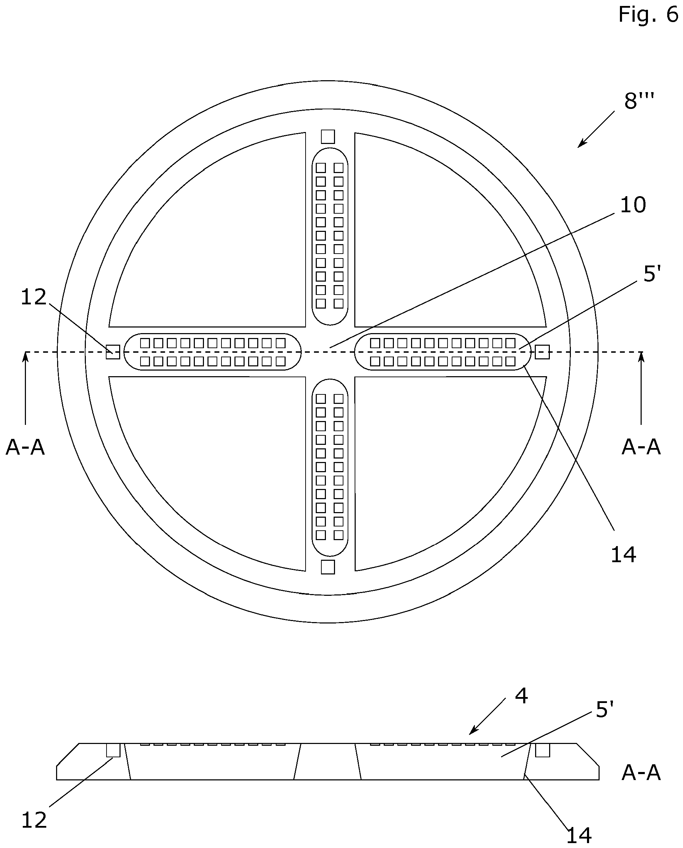

Die Figur 6 zeigt eine vierte, weiter verbesserte Ausführungsform des Substrathalters 8‴. Der Substrathalter 8‴ verfügt über Streben 10 mit, insbesondere konisch verlaufenden, Durchgängen 14. In den Durchgängen 14 sind einzelne, insbesondere als Einsätze ausgebildete, Markenfeldträger 5' aufnehmbar oder fixiert, die über Markenfelder 4 verfügen. Die Fixiermittel 12 befinden sich in dieser speziellen Ausführungsform beispielsweise im Substrathalter 8‴.

Insbesondere weisen ausschließlich die Streben 10 Markenfelder 4 auf, so dass in den Freibereichen zwischen den Streben 10 keine Marken vorgesehen sind. Der Substrathalter 8‴ ist somit sehr filigran und leicht ausgebildet sowie einfach herstellbar. Er weist trotz der geringeren Dicke eine hohe Steifigkeit auf. Weiterhin können die Markenfeldträger 5' und somit die Markenfelder 4 einfacher ausgetauscht werden.

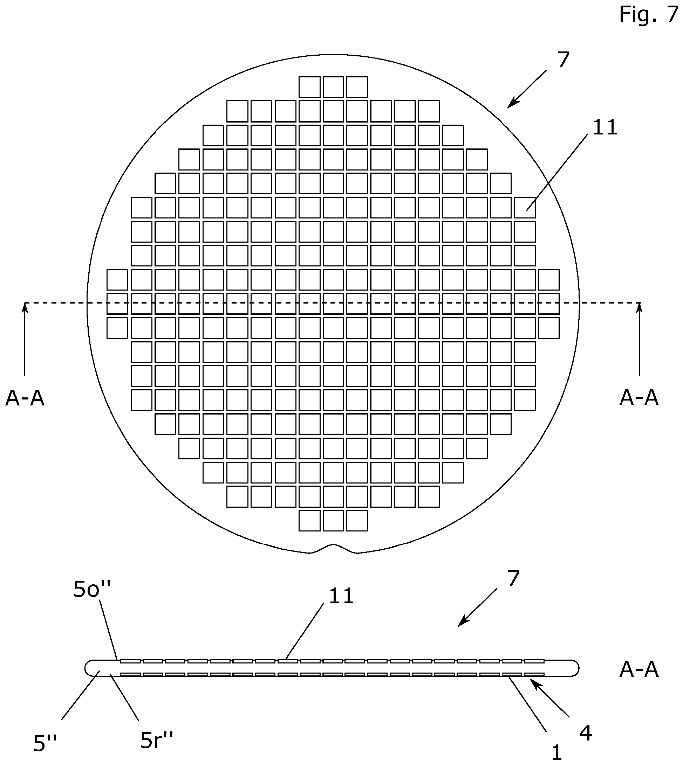

Die Figur 7 zeigt eine fünfte, weniger bevorzugte Ausführungsform des Markenfeldträgers 5", der hier durch das Substrat 7 selbst gebildet ist. Das Substrat 7 weist auf einer Seite (Markenfeldträgerrückseite 5r") Strukturen 11 und auf der gegenüberliegenden Seite das Markenfeld 4 auf. Diese spezielle Ausführungsform ist nur dann sinnvoll, wenn man sicherstellen kann, dass sich die Markenfeldträgerrückseite 5r", auf der sich das Markenfeld 4 befindet, nicht verformt.

Die Figur 8 zeigt den Substrathalter 8' mit dem eingesetzten und fixierten transparenten Markenfeldträger 5, auf dem das Substrat 7 mit Strukturen 11 mittels der Fixiermittel 12 fixiert ist.

Eine erste, insbesondere obere, Optik 13 erfasst mit einem (vergrößert dargestellten) Sichtbereich die Substratoberfläche 70, auf der die Strukturen 11 angeordnet sind. Die erste Optik 13' ist auf die Strukturen 11 fokussiert.

Eine zweite, mit der ersten Optik 13 insbesondere kalibrierte, vorzugsweise kongruente, Optik 13' erfasst die Markenfeldträgeroberfläche 5o mit dem Markenfeld 4 durch den transparenten Markenfeldträger 5 hindurch. Die zweite Optik 13' ist auf die Marken 2 fokussiert.

Die erfassten Bilder werden, insbesondere digital, überlagert und ergeben ein Überlagerungsbild, aus dem Abstände dx und dy eines (oder mehrerer) Strukturmerkmals 11c (hier: obere linke Ecke der Struktur 11) zu der hochgenauen Positionsmarke 3 bezogen auf ein X-Y-Koordinatensystem bestimmt werden.

Bei dem in Figur 8 gezeigten Beispiel sind die Ecken der Struktur 11 (Strukturmerkmale 11c) nicht deckungsgleich mit der Positionsmarke 3, die Abstände dx und dy sind also ungleich Null. Des Weiteren ist die Struktur 11 gegenüber der Referenz-Ausrichtung der Positionsmarke 3 leicht gedreht.

Im Sichtbereich der Optiken 13, 13' beziehungsweise dem Überlagerungsbild erkennbar ist außerdem die Lagemarke 2, die Auskunft über die grobe Position erlaubt.

Aus einer Erfassung mehrerer Strukturmerkmale 11c kann der Rotationszustand und/oder eine Verformung der Struktur 11 bestimmt werden.

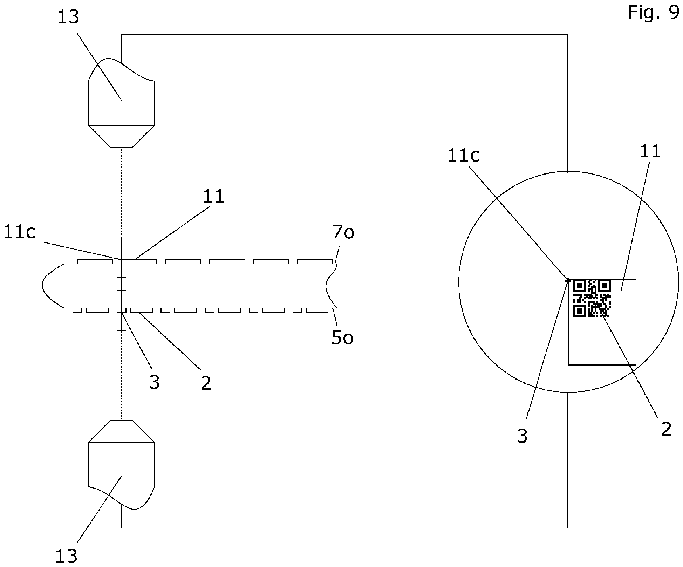

Die Figuren 9 bis 13 zeigen weitere Erfassungsschritte an unterschiedlichen Fallbeispielen, die sich wie folgt unterscheiden:

Figur 9: Die optischen Achsen der beiden Optiken 13 sind kongruent zueinander. Des Weiteren befinden sich die charakteristischen Strukturmerkmale 11c der Strukturen 11 direkt über den für die Positionsvermessung relevanten Positionsmarken 3. Dementsprechend ergibt sich ein ideales Überlagerungsbild. Ein weiteres Merkmal besteht darin, dass die Dichte der Strukturen 11 auf der Substratoberfläche 7o identisch ist mit der Dichte der Positionsmarken 3 auf der Markenfeldträgeroberfläche 5o. Vorzugsweise wird ein Markenfeldträger 5 konstruiert, der für unterschiedliche Substrate 7 mit unterschiedlichen Dichten an Strukturen 11 verwendbar ist.

Die Dichte der Marken 1 ist erfindungsgemäß insbesondere höher als die Dichte der Strukturen 11. Somit wird gewährleistet, dass im Bereich einer Struktur 11 und/oder eines Strukturmerkmals 11c mindestens eine Marke 1 im Sichtbereich der Optiken 13, 13' liegt.

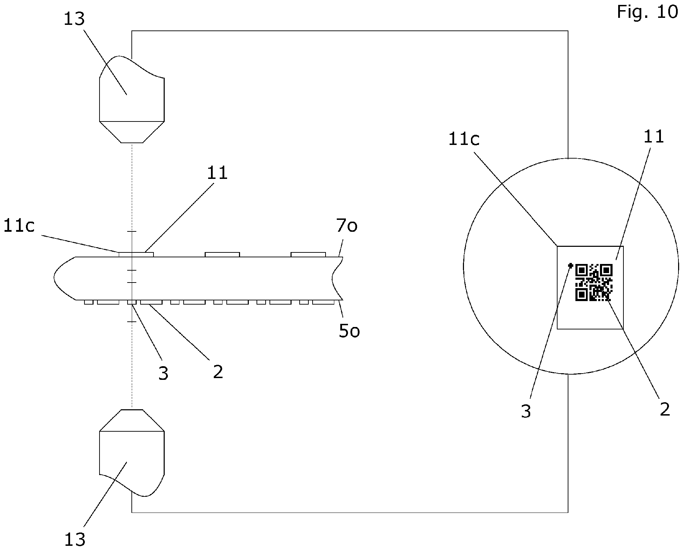

Figur 10: Die optischen Achsen der beiden Optiken 13 sind kongruent zueinander. Im vorliegenden Fall befinden sich die charakteristischen Merkmale 11c der Strukturen 11 nicht direkt über den für die Positionsvermessung relevanten Positionsmarken 3. Die sich im Überlagerungsbild ergebene Differenz ist ausschließlich auf die Verschiebung zwischen der Positionsmarken 3 und den Strukturen 11 zurückzuführen und beruht nicht auf einem optischen Fehler. Ein weiteres Merkmal besteht darin, dass die Dichte der Strukturen 11 auf der Substratoberfläche 7o nicht identisch ist mit der Dichte der Positionsmarken 3 auf der Markenfeldträgeroberfläche 5o.

Aus der vorliegenden Figur ist auch erkennbar, dass es zwar eine translatorische Verschiebung zwischen den Strukturen 11, genauer den charakteristischen Merkmalen 11c der Strukturen 11 und den Positionsmarken 3 gibt, diese allerdings für alle (gezeigten) Überlagerungsbilder gleich sind. Das ist gleichbedeutend mit der Aussage, dass man das Substrat 7 nur relativ zum Markenfeldträger 5 verschieben müsste, um den Deckungszustand aus der Figur 9 zu erhalten (natürlich nur für jede zweite Struktur 11, da die Dichte der Strukturen in Figur 10 nur halb so groß ist als die Dichte in Figur 9).

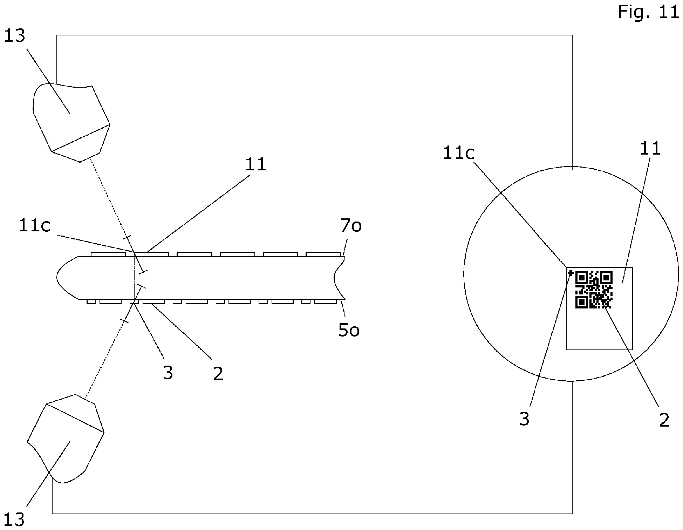

Figur 11: Die optischen Achsen der beiden Optiken 13, 13' sind nicht kongruent, nicht einmal parallel zueinander. Es kann daher nicht davon ausgegangen werden, dass die charakteristischen Strukturmerkmale 11c einer Struktur 11 mit der jeweiligen Positionsmarke 3 (selbst wenn sie exakt übereinanderliegen) im Überlagerungsbild deckungsgleich sind. Die Schrägstellung der optischen Achsen, genauso wie Änderungen in der Dicke des Substrats 7, ein Keilfehler des Substrats 7, etc. führen dazu, dass selbst unter idealen Bedingungen die Überlagerungsbilder nicht ideal sind. Um diese Arten von optischen Fehlern zu korrigieren, wird (wie oben beschrieben) eine Drehung um 180° durchgeführt, eine zweite Vermessung aller Strukturen vorgenommen und aus dem Mittelwert der so ermittelten Positionen der charakteristischen Strukturmerkmale 11c der Strukturen 11 der optische Fehler, welcher maßgeblich auf die Schrägstellung der optischen Achsen zurückzuführen ist, herausgerechnet.

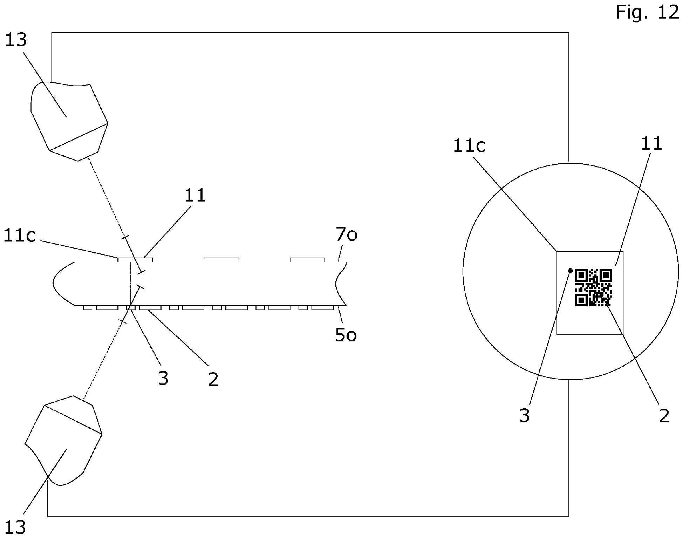

Figur 12: Die Dichte der Strukturen 11 ist unterschiedlich zur Dichte der Positionsmarken 3. Die charakteristischen Strukturmerkmale 11c sind nicht deckungsgleich zu den Positionsmarken 3 und die optischen Achsen der Optiken 3 sind weder kongruent noch parallel zueinander. Durch die Eliminierung des Fehlers, der aus den optischen Achsen hervorgeht, gemäß der Beschreibung aus Figur 11, verbleibt dann noch ein Überlagerungsbild gemäß Figur 10.

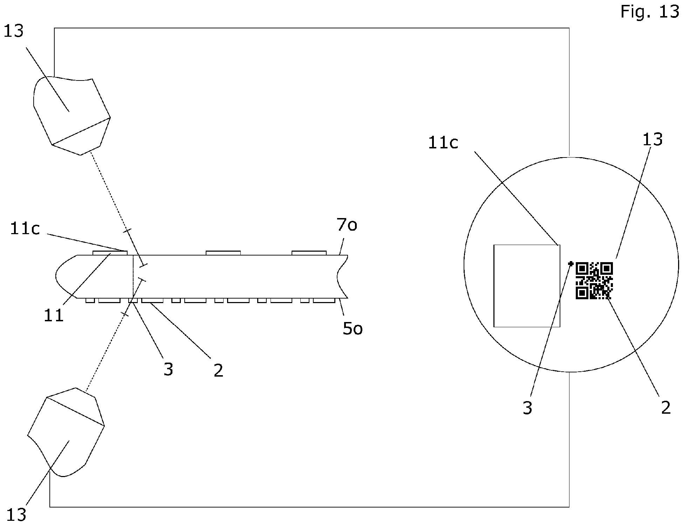

Figur 13: Diese Ausführungsform zeigt den erfindungsgemäß bevorzugten Fall. Wiederum sind die Dichten der Strukturen 11 und der Positionsmarken 3 unterschiedlich. Durch die schrägen optischen Achsen entsteht ein optischer Fehler im Überlagerungsbild, der durch 180° Drehung und eine zweite vollständige Vermessung aller Strukturen herausgerechnet wird. Des Weiteren befindet sich die Struktur 11 viel zu weit links. Denkbar ist, dass die Oberfläche durch einen Prozess verzerrt wurde und/oder dass sich dieser Teil auf Grund einer thermischen Beaufschlagung stärker thermisch gedehnt hat. Die Verschiebung der Struktur 11 hat also nichts mehr mit der globalen Verschiebung aller Strukturen 11 in Bezug zum Markenfeld 4 zu tun, die insbesondere darauf zurückzuführen sein kann, dass das Substrat 7 eine Verschiebung als Ganzes in Bezug zum Markenfeld 4 erfahren hat. Diese Verschiebung der Struktur 11 ist ortsspezifisch und immanent. Wichtig ist vor allem, dass das darunterliegende Markenfeld 4 hochsymmetrisch ist und bleibt.

Die folgenden Figuren dienen der weiteren Erläuterung möglicher Fehlerquellen und die diesbezüglichen Maßnahmen des erfindungsgemäßen Verfahrens, um die Fehlerquellen bei der Bestimmung ermitteln und auswerten zu können.

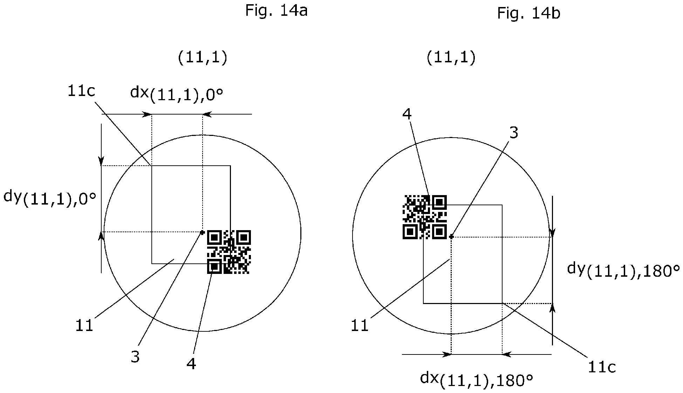

Die Figur 14a zeigt ein Überlagerungsbild einer Struktur 11 mit einer Positionsmarke 3 und einer Lagemarke 2 an einer Position (11,1) in einer Rotationslage von 0°. Erfasst werden die Abstände dx(11,1),0° und dy(11,1),0° zwischen der Positionsmarke 3 und dem charakteristischen Strukturmerkmal 11c der Struktur 11.

Die Figur 14b zeigt ein Überlagerungsbild einer Struktur 11 mit einer Positionsmarke 3 und einer Lagemarke 2 an einer ersten Position (11,1) in einer Rotationslage von 180°. Erfasst werden die Abstände dx(11,1),180° und dy(11,1),180° zwischen der Positionsmarke 3 und dem charakteristischen Strukturmerkmal 11c der Struktur 11.

Aus den Werten dx(11,1),0° und dx(11,1),180° bzw. dy(11,1),0° und dy(11,1),180° lassen sich die Fehler, die durch die Schrägstellung der optischen Achsen und anderer Fehlerquellen entstehen, in x- bzw. y Richtung herausrechnen, sodass der reine Versetz zwischen der Positionsmarke 3 und dem charakteristischen Merkmal 11c der Struktur 11 ermittelt (berechnet) werden kann.

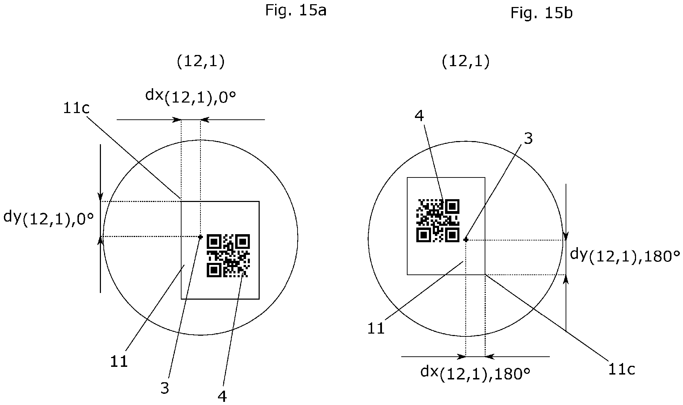

Die Figuren 15a und 15b zeigen eine andere Struktur 11 an einer zweiten Position (12,1), wiederum in den zwei unterschiedlichen Rotationslagen von 0° und 180°. Auch hier können die Fehler, die durch die Schrägstellung der optischen Achsen und anderer Fehlerquellen entstehen, in x- bzw. y-Richtung herausgerechnet werden. Die Figuren 14 und 15 sollen veranschaulichen, dass die horizontalen und/oder vertikalen Differenzen zwischen den Positionsmarken 3 und den charakteristischen Strukturmerkmalen 11c an unterschiedlichen Positionen sehr stark abweichen können. Diese Abweichungen sind vor allem das Resultat aus Verzerrungen, Dehnungen etc.

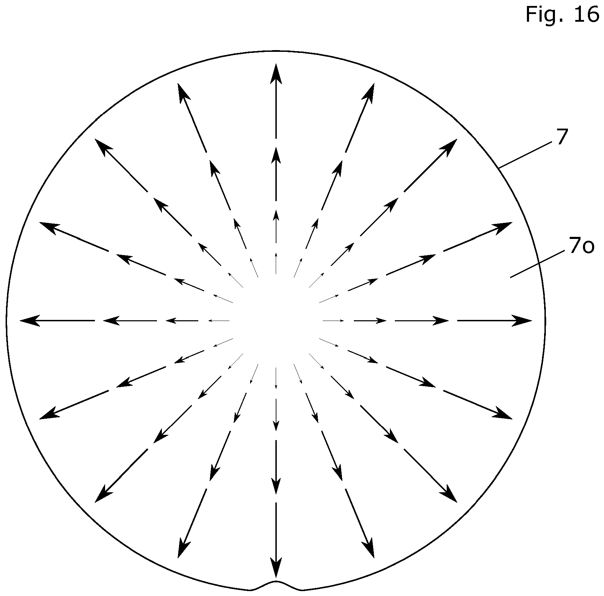

Die Figur 16 zeigt ein Vektorfeld. Das Vektorfeld beschreibt schematisch, wie die Strukturen 11 (hier nicht eingezeichnet) als Funktion des Ortes verformt werden. Die Größe der Pfeile nimmt vom Zentrum nach außen hin zu. Damit wird angedeutet, dass die Strukturen zum Rand des Substrats 7 hin gestreckt werden. Die Länge der Pfeile nimmt zu. Damit wird angedeutet, dass die translatorische Verschiebung zum Rand hin zunimmt. Hier handelt es sich also um einen klassischen run-out-Fehler. Da keiner der Pfeile eine Tangentialkomponente aufweist, ist keine rotatorische Abweichung ermittelt worden. In der Praxis sehen die erfindungsgemäß ermittelten Vektorfelder komplizierter aus.

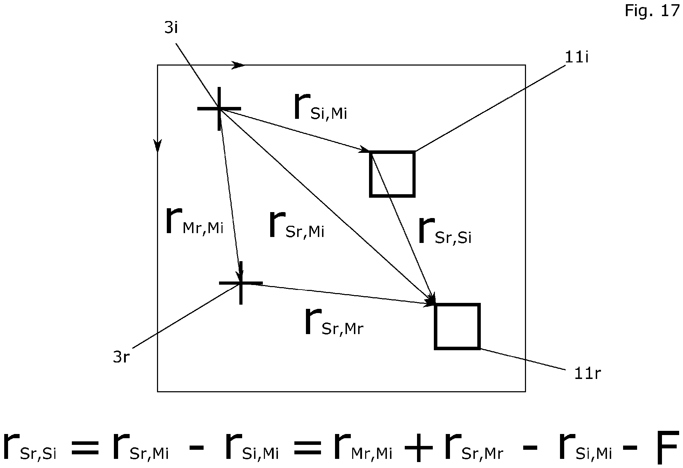

Die Figur 17 zeigt eine schematische Darstellung eines Ausschnitts der Bildüberlagerung von idealen und realen Strukturen und Positionsmarken in einer Lage. Die Darstellung dient der mathematischen Veranschaulichung des Zusammenhangs der unterschiedlichen berechenbaren und messbaren Größen. Auf die exakte Darstellung der Lagemarken wird der Einfachheit halber verzichtet. Die Koordinatenachsen der Koordinatensysteme der idealen und realen Ebenen wurden bereits zueinander angepasst, sodass alle Koordinatensysteme zueinander dieselbe Orientierung und denselben Ursprung haben. Mit Ausnahme des optischen Fehlers, der nicht explizit eingezeichnet wurde, sondern nur in der Formel Erwähnung findet, sind alle anderen Differenzenvektorbeziehungen erkennbar. Die Position der idealen Positionsmarke 3i, sowie die Position der idealen Struktur 11i liegen im Computer vor. Die Position der realen Positionsmarke 3r, sowie die Position der realen Struktur 11r werden gemessen. Erfindungsgemäß kann der Differenzenvektor $r_{Sr,Mr}$ vermessen werden. Der Differenzenvektor $r_{Si,Mi}$ kann direkt aus den Computerdaten ermittelt werden. Es bedarf hier keiner Messung. Der Differenzenvektor $r_{Mr,Mi}$ kann ebenfalls vermessen werden. Aus den gewonnenen Daten lässt sich der Differenzenvektor $r_{Sr,Si}$, also die Abweichung der Position der realen Struktur 11r von der Position der idealen Struktur 11i berechnen.

Bezugszeichenliste

| 1, 1' | Marke |
|---|---|
| 2 | Lagemarke |
| 3, 3',3i, 3r | Positionsmarke |
| 4 | Markenfeld |
| 5, 5', 5" | Markenfeldträger |
| 5o, So', 5o" | Markenfeldträgeroberfläche |
| 5r, 5r" | Markenfeldträgerrückseite |
| 6 | Körperfestes Koordinatensystem |
| 7 | Substrat |
| 7o | Substratoberfläche |
| 8, 8', 8", 8''' | Substrathalter |
| 8o | Substrathalteroberfläche |
| 8r | Substrathalterrückseite |
| 9 | Fixierelemente |
| 10 | Streben |
| 11, 11i, 11r | Strukturen |
| 11c | Charakteristisches Strukturmerkmal |
| 12 | Fixiermittel |
| 13, 13' | Optiken |
| 14 | Durchgänge |

**Patentansprüche**

1. Vorrichtung zur Bestimmung von X-Y-Positionen von Strukturmerkmalen (11c) von auf einem Substrat (7) angeordneten Strukturen (11), wobei die X-Y-Positionen relativ zu einem bezogen auf das Substrat fixen Markenfeld (4) bestimmbar sind, wobei die Vorrichtung einen Substrathalter (8, 8', 8", 8''') und einen Markenfeldträger (5,5',5") aufweist, wobei das Markenfeld (4) auf dem Markenfeldträger (5,5',5") angeordnet ist, das Markenfeld (4) aufweisend

   - mindestens zwei Lagemarken (2) mit Informationen zur Lage der jeweiligen Lagemarke (2) im Markenfeld (4) und
   - mindestens eine einer der Lagemarken (2) zugeordnete oder zuordenbare Positionsmarke (3),
   wobei das Markenfeld (4) auf dem Substrathalter (8, 8', 8", 8''') angeordnet ist, wobei die X-Y-Positionen mit dem Markenfeld (4) assoziiert werden,
   **dadurch gekennzeichnet, dass**
   die Vorrichtung mindestens zwei Optiken (13,13') zur Erfassung des Markenfeldes (4) aufweist, wobei die Optiken (13,13') derart konstruiert und angeordnet sind, dass die Optiken (13,13') aufeinander zu gerichtet sind, wobei der Substrathalter (8, 8', 8", 8''') eine Fixieroberfläche (8o) zur Fixierung des Substrats (7) aufweist, wobei das Markenfeld (4) auf der Fixieroberfläche (8o) oder auf einer der Fixieroberfläche (8o) gegenüberliegenden Oberfläche (8r) des Substrathalters (8, 8', 8", 8''') angeordnet ist.

**2.** Vorrichtung nach Anspruch 1, wobei die Lagemarken (2) und/oder Positionsmarken (3) in einem, insbesondere symmetrischen, Raster mit einheitlichen Abständen zwischen den Lagemarken (2) und/oder Positionsmarken (3) angeordnet sind.

**3.** Vorrichtung nach Anspruch 1 oder 2, wobei benachbarte Lagemarken (2) und/oder benachbarte Positionsmarken (3) äquidistant auf dem Markenfeld (4) angeordnet sind.

**4.** Vorrichtung nach einem oder mehreren der Ansprüche 1 bis 3, wobei das Markenfeld (4) mindestens 10 x 10 Marken (1), vorzugsweise mindestens 100 x 100 Marken (1), noch bevorzugter mehr als 1000 x 1000 Marken (1), am bevorzugtesten mehr als 10000 x 10000 Marken (1), am allerbevorzugtesten mehr als 100000 x 100000 Marken (1) aufweist.

**5.** Vorrichtung nach einem oder mehreren der Ansprüche 1 bis 4, wobei Abstände zwischen benachbarten Lagemarken (2) kleiner als die Breite und/oder Höhe oder der Durchmesser der Lagemarken (2) sind, insbesondere mit einem Verhältnis zwischen dem Abstand und der Breite und/oder Höhe oder dem Durchmesser der Lagemarken (2) kleiner als 1, noch bevorzugter kleiner als 0.5, noch bevorzugter kleiner als 0.1.

**6.** Vorrichtung nach einem oder mehreren der Ansprüche 1 bis 5, wobei jede Marke (1) des Markenfeldes (4) unterschiedlich ist, insbesondere eine unterschiedliche Kodierung, vorzugsweise eine Positionskodierung, aufweist.

**7.** Vorrichtung nach einem oder mehreren der Ansprüche 1 bis 6, wobei die Lagemarke eine oder mehrere der folgenden Ausprägungen aufweist:

    • QR Code,
    • Strichcode,
    • Geometrische, insbesondere dreidimensionale, Figur,
    • Zeichenfolge, insbesondre Buchstabenfolge und/oder Zahlenfolge, vorzugsweise Binärcode,
    • Bild.

**8.** Verfahren zur Bestimmung von X-Y-Positionen von Strukturmerkmalen (11c) von auf einem Substrat (7) angeordneten Strukturen (11), wobei die X-Y-Positionen relativ zu einem bezogen auf das Substrat (7) fixen Markenfeld (4) bestimmt werden, wobei das Markenfeld (4) auf einem Markenfeldträger (5,5',5") angeordnet ist, das

    - mindestens zwei Lagemarken (2) mit Informationen zur Lage der jeweiligen Lagemarke (2) im Markenfeld (4) und
    - mindestens eine einer der Lagemarken (4) zugeordnete oder zuordenbare Positionsmarke (3)

aufweist,
wobei das Markenfeld (4) auf einem Substrathalter (8, 8', 8", 8‴) angeordnet ist, wobei die X-Y-Positionen mit dem Markenfeld (4) assoziiert werden, **dadurch gekennzeichnet, dass** das Markenfeld (4) durch mindestens zwei Optiken (13,13') erfasst wird, wobei die Optiken (13,13') derart konstruiert und angeordnet sind, dass die Optiken (13,13') aufeinander zu gerichtet sind, wobei der Substrathalter (8, 8', 8", 8‴) eine Fixieroberfläche (8o) zur Fixierung des Substrats (7) aufweist, wobei das Markenfeld (4) auf der Fixieroberfläche (8o) oder auf einer der Fixieroberfläche (8o) gegenüberliegenden Oberfläche (8r) des Substrathalters (8, 8', 8", 8‴) angeordnet ist.

**Claims**

**1.** A device for the determination of X-Y positions of structural features (11c) of structures (11) arranged on a substrate (7), wherein the X-Y positions can be determined relative to a mark field (4) fixed in relation to the substrate, wherein the device comprises a substrate holder (8, 8', 8", 8‴) and a mark field carrier (5, 5', 5"), wherein the mark field (4) is arranged on the mark field carrier (5, 5', 5"), the mark field (4) comprising

    - at least two location marks (2) with information concerning the location of the respective location mark (2) in the mark field (4) and
    - at least one position mark (3) assigned or assignable to one of the location marks (2),
wherein the mark field (4) is arranged on the substrate holder (8, 8', 8", 8‴), wherein the X-Y positions are associated with the mark field (4), **characterised in that** the device comprises at least two lenses (13, 13') for the detection of the field mark (4), wherein the lenses (13, 13') are designed and arranged in such a way that the lenses (13, 13') are directed towards one another, wherein the substrate holder (8, 8', 8", 8‴) comprises a fixing surface (8o) for fixing the substrate (7), wherein the mark field (4) is arranged on the fixing surface (8o) or on a surface (8r) of the substrate holder (8, 8', 8", 8‴) lying opposite the fixing surface (8o).

**2.** The device according to claim 1, wherein the location marks (2) and/or position marks (3) are arranged in an, in particular symmetrical, grid with uniform spacings between the location marks (2) and/or position marks (3).

**3.** The device according to claim 1 or 2, wherein adjacent location marks (2) and/or adjacent position marks (3) are arranged equidistant on the mark field (4).

**4.** The device according to one or more of claims 1 to 3, wherein the mark field (4) comprises at least $10 \times 10$ marks (1), preferably 100x100 marks (1), still more preferably more than 1000x1000 marks (1), most preferably more than $10000 \times 10000$ marks (1), with utmost preference more than $100000 \times 100000$ marks (1).

**5.** The device according to one or more of claims 1 to 4, wherein spacings between adjacent location marks (2) are less than the width and/or height or the diameter of the location marks (2), in particular with a ratio between the spacing and the width and/or height or the diameter of the location marks less than 1, more preferably less than 0.5, still more preferably less than 0.1.

**6.** The device according to one or more of claims 1 to 5, wherein each mark (1) of the mark field (4) is different, in particular comprises a different coding, preferably a position coding.

**7.** The device according to one or more of claims 1 to 6, wherein the location mark comprises one or more of the following forms.

- QR code,
- barcode,
- geometrical, in particular three-dimensional, figure
- character sequence, in particular letter sequence and/or numerical sequence, preferably a binary code,
- image

**8.** A method for the determination of X-Y positions of structural features (11c) of structures (11) arranged on a substrate (7), wherein the X-Y positions are determined relative to a mark field (4) fixed in relation to the substrate (7), wherein the mark field (4) is arranged on a mark field carrier (5, 5', 5"), which comprises

- at least two location marks (2) with information concerning the position of the respective location mark (2) in the mark field (4) and
- at least one position mark (3) assigned or assignable to one of the location marks (4),

wherein the mark field (4) is arranged on a substrate holder (8, 8', 8", 8‴), wherein the X-Y positions are associated with the mark field (4), **characterised in that** the mark field (4) is detected by at least two lenses (13, 13'), wherein the lenses are designed and arranged in such a way that the lenses (13, 13') are directed towards one another, wherein the substrate holder (8, 8', 8", 8‴) comprises a fixing surface (8o) for fixing the substrate (7), wherein the mark field (4) is arranged on the fixing surface (8o) or on a surface (8r) of the substrate holder (8, 8', 8', 8‴) lying opposite the fixing surface (8o).

**Revendications**

**1.** Dispositif de détermination de positions X-Y de caractéristiques de structure (11c) de structures (11) disposées sur un substrat (7), dans lequel les positions X-Y peuvent être déterminées par rapport à un champ de repères (4) fixe par rapport au substrat, dans lequel le dispositif présente un porte-subtrats (8, 8', 8", 8‴) et un support de champ de repères (5, 5', 5"), dans lequel le champ de repères (4) est disposé sur le support de champ de repères (5, 5', 5"), le champ de repères (4) présentant

- au moins deux repères de situation (2) avec des informations sur la situation du repère de situation (2) respectif dans le champ de repères (4) et
- au moins un repère de position (3) pouvant être attribué ou attribué à un des repères de situation (2),

dans lequel le champ de repères (4) est disposé sur le porte-subtrats (8, 8', 8", 8‴), dans lequel les positions X-Y sont associées au champ de repères (4),

**caractérisé en ce que**

le dispositif présente au moins deux optiques (13, 13') pour détecter le champ de repères (4), dans lequel les optiques (13, 13') sont construites et disposées de telle façon que les optiques (13, 13') sont dirigées l'une sur l'autre, dans lequel le porte-subtrats (8, 8', 8", 8‴) présente une surface de fixation (8o) pour fixer le substrat (7), dans lequel le champ de repères (4) est disposé sur la surface de fixation (8o) ou sur une surface (8r) du porte-subtrats (8, 8', 8", 8‴) opposée à la surface de fixation (8o).

**2.** Dispositif selon la revendication 1, dans lequel les repères de situation (2) et/ou les repères de position (3) sont disposés dans une grille en particulier symétrique, avec des écarts uniformes entre les repères de situation (2) et/ou les repères de position (3).

**3.** Dispositif selon la revendication 1 ou 2, dans lequel des repères de situation (2) adjacents et/ou des repères de position (3) adjacents sont disposés à équidistance sur le champ de repères (4).

4.  Dispositif selon l'une ou plusieurs des revendications 1 à 3, dans lequel le champ de repères (4) présente des repères (1) d'au moins 10 × 10, de préférence des repères (1) d'au moins 100 × 100, de manière plus préférée des repères (1) de plus de 1000 × 1000, de manière la plus préférée des repères (1) de plus de 10000 × 10000, de manière préférée entre toutes des repères (1) de plus de 100000 × 100000.

5.  Dispositif selon l'une ou plusieurs des revendications 1 à 4, dans lequel des écarts entre des repères de situation (2) adjacents sont plus petits que la largeur et/ou la hauteur ou le diamètre des repères de situation (2), en particulier avec un rapport entre l'écart et la largeur et/ou la hauteur ou le diamètre des repères de situation (2) inférieur à 1, de manière plus préférée inférieur à 0,5, de manière plus préférée inférieur à 0,1.

6.  Dispositif selon l'une ou plusieurs des revendications 1 à 5, dans lequel chaque marque (1) du champ de repères (4) est différent, présente en particulier un codage différent, de préférence un codage de position.

7.  Dispositif selon l'une ou plusieurs des revendications 1 à 6, dans lequel le repère de situation présente un ou plusieurs des marquages suivants :

    - code QR,
    - code barre,
    - figure géométrique, en particulier tri-dimensionnelle,
    - suite de signes, en particulier suite de lettres et/ou suite de nombres, de préférence code binaire,
    - image.

8.  Procédé de détermination de positions X-Y de caractéristiques de structure (11c) de structures (11) disposées sur un substrat (7), dans lequel les positions X-Y peuvent être déterminées par rapport à un champ de repères (4) fixe par rapport au substrat (7), dans lequel le champ de repères (4) est disposé sur le support de champ de repères (5, 5', 5"), qui présente

    - au moins deux repères de situation (2) avec des informations sur la situation du repère de situation (2) respectif dans le champ de repères (4) et
    - au moins un repère de position (3) pouvant être attribué ou attribué à au moins un des repères de situation (4),
    dans lequel le champ de repères (4) est disposé sur un porte-subtrats (8, 8', 8", 8'''), dans lequel les positions X-Y sont associés au champ de repères (4),
**caractérisé en ce que**
le champ de repères (4) est détecté par au moins deux optiques (13, 13'), dans lequel les optiques (13, 13') sont construites et disposées de telle façon que les optiques (13, 13') sont dirigées l'une sur l'autre, dans lequel le porte-subtrats (8, 8', 8", 8''') présente une surface de fixation (8o) pour fixer le substrat (7), dans lequel le champ de repères (4) est disposé sur la surface de fixation (8o) ou sur une surface (8r) du porte-subtrats (8, 8', 8", 8''') opposée à la surface de fixation (8o).

Fig. 1a

Fig. 1b

Fig. 2

Fig. 3

Fig. 4

Fig. 5

Fig. 6

Fig. 7

Fig. 8

Fig. 9

Fig. 10

13

11

11c

7o

5o

3    2

13

11c

11

3    2

Fig. 11

Fig. 12

Fig. 13

Fig. 14a

Fig. 14b

(11,1)

(11,1)

11c

dx(11,1),0°

dy(11,1),0°

11

3

4

4

3

11

dy(11,1),180°

11c

dx(11,1),180°

Fig. 15a

Fig. 15b

(12,1)

(12,1)

dx(12,1),0°

11c

dy(12,1),0°

11

3

4

4

3

dy(12,1),180°

11

dx(12,1),180°

11c

Fig. 16

Fig. 17

$$r_{Sr,Si} = r_{Sr,Mi} - r_{Si,Mi} = r_{Mr,Mi} + r_{Sr,Mr} - r_{Si,Mi} - F$$

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1932933 A1
- WO 2015113641 A1
- WO 2014202106 A1